# EUROPEAN PATENT APPLICATION

(11) **EP 1 667 216 A2**
(43) Date of publication of application: **07.06.2006**
(21) Application number: 05026462.1
(22) Date of filing: 05.12.2005
(51) Int. Cl.: H01L 21/3065

(54) **Dielectric etch method with high density and low bombardment energy plasma providing high etch rates**

(30) Priority: 03.12.2004 US 3227
(71) Applicant: APPLIED MATERIALS, INC., Santa Clara, California 95054 (US)
(72) Inventor: Delgadino, Gerardo A., Santa Clara CA 95051 (US); Hsieh, Chang-Lin, San Jose CA 95129 (US); Ye, Yan, Saratoga CA 95070 (US); Shim, Hyunjong, Pleasanton CA 94588 (US)
(74) Representative: Zimmermann, Gerd Heinrich

(57) **Abstract**

In at least some embodiments, the present invention is a plasma etching method which includes applying a gas mixture comprising CF₄, N₂ and Ar and forming a high density and low bombardment energy plasma. The high density and low bombardment energy plasma is formed by using high source and low bias power settings. The gas mixture can further include H₂, NH₃, a hydrofluorocarbon gas and/or a fluorocarbon gas. The hydrofluorocarbon gas can include CH₂F₂, CH₃F; and/or CHF₃. The fluorocarbon gas can include C₄F₈, C₄F₆ and/or C₅F₈.

## Description

The present invention relates to etching of semiconductor wafers. Particularly, the present invention relates to etching with high etch rates. Specifically, it relates to a plasma etching method, a method for etching a feature in a plasma reactor, an etching method and a plasma etching tool.

The production rate of semi-conductor or thin-film devices can be increased by decreasing the time required to perform one or more steps of the fabrication processes. Not only does this reduce the overall time to produce a device, but it provides a greater overall production capacity for a given suite of fabrication equipment. In turn, allowing a reduction in the amount of initial capital investment and/or expansion expenditure needed.

However, increasing the speed of any of the production steps must be done in a manner that continues to maintain a desired level of quality. Failing to preserve quality levels will offset any increased production by a reduction in device yield, due to more defects and device failures.

One common step in the fabrication of semi-conductor or thin-film devices is etching. Etching can be a wet etch, where a liquid acid is typically used, or a dry etch, which is a more common method involving the application of a plasma to etch the device.

During a dry etch it is highly desirable to have the etch form features (such as vias and trenches), that are well defined with sidewalls as vertical as possible. Well defined structures reduce the potential for defects (e.g. shorting) and reduce the amount of separation needed between features or elements. Vertical sidewalls are beneficial as they allow deeper (e.g. higher aspect ratios) and more uniform structures to be created.

Approaches which have attempted to increase etch rates have included increasing the bombardment energy and/or the plasma density. The bombardment energy is increased by increasing the bias, and the plasma density is increased by increasing the source power.

While such approaches have resulted in higher etch rates, they have not been without some significant problems. For example, by increasing the bias to 3500 Watts, etch rates of about 7000-7500 ÅÅ/min have been achieved. However, by increasing the bombardment energy, the selectivity to the photoresist is reduced and striations are formed about, and extending out from, the etched feature. Also, increasing the density causes the sidewalls of the feature to have tapered profiles, that is, the sidewalls do not have vertical (or near vertical) shapes. Higher density levels also cause the etch to terminate prior to the desired stop point.

As a result, while the rate of etching can be increased by either increasing the bombardment energy or increasing the density, the resulting feature will be significantly deformed with striations, taper sidewalls and/or inadequate depth. These deformations can cause major defects in, and failures of, the resulting devices. As such, increasing the etch rate in this manner can result in an unacceptable decrease in the overall production yield.

Therefore, a need exists for an etching method that provides an increase in etch rate, while maintaining an acceptable level of product quality. That is, the method should supply a faster etch rate with the resulting etched features properly defined, having vertical (or near vertical) sidewalls, and extending to desired depths.

In light of the above the present invention provides a plasma etch method according to independent claims 1, a method for etching a feature in a plasma reactor according to independent claim 20, an etching method according to independent claims 61 and 66, and a plasma etching tool according to independent claim 71.

Typical embodiments of the present invention are set forth in the dependent claims, the detailed description and the drawings.

In at least some embodiments, the present invention is a plasma etching method which includes applying a gas mixture comprising CF₄, N₂ and Ar and forming a high density and low bombardment energy plasma. The high density and low bombardment energy plasma is formed by using high source and low bias power settings. The density or electron density, can, depending on the embodiment, range from about 5x10¹⁰ electrons/cm³ and above, including about 1x10¹¹ electrons/cm³ and above. The gas mixture can further include H₂, NH₃, a hydrofluorocarbon gas and/or a fluorocarbon gas. The hydrofluorocarbon gas can include CH₂F₂, CH₃F; and/or CHF₃. The fluorocarbon gas can include C₄F₈, C₄F₆ and/or C₅F₈.

In additional embodiments, the present invention is a method for etching a feature, which includes: providing a semiconductor wafer; applying upon the semiconductor wafer a gas mixture including CF₄, N₂ and Ar; forming a plasma with a high source power and a low bias power; and etching the semiconductor wafer to form a feature in the semiconductor wafer.

The gas mixture for these embodiments can further include H₂, NH₃, hydrofluorocarbon gas and/or a fluorocarbon gas. The hydrofluorocarbon gas can include CH₂F₂, CH₃F; and/or CHF₃. The fluorocarbon gas can include C₄F₈, C₄F₆ and/or C₅F₈. For certain embodiments, the flow rates of the gases in the gas mixture are about 65 sccm (standard cubic centimeters per minute, Standard conditions are 1013.25 mbar and 273.15 K (standard conditions), At 20°C: 1 mbar l/s = 55.18 sccm) for CF₄, about 170 sccm for N₂ and about 500 sccm for Ar. The flow rates of the additional gases can be about 20 sccm for H₂, about 10 sccm for C₄F₈, about 10 sccm for CH₂F₂ and about 20 sccm for NH₃.

The semiconductor wafer can have a diameter of about 200mm to about 300 mm. In embodiments having a 300mm wafer, the high source power can be between about 400 Watts and 2000 Watts and the low bias power is between about 600 Watts and 3000 Watts. In particular embodiments, the high source power is about 1000 Watts to about 1500 Watts and the low bias power is about 2800 Watts.

The semiconductor wafer can include a dielectric material that is etched to form a feature such as a via or a trench. The dielectric material can be a low-k dielectric material. The dielectric constant of the material can be between about 2.0 and about 3.6.

In some embodiments which use a 200 mm wafer, the CF₄ is applied at a flow rate of about 0 sccm, the N₂ at a flow rate of about 0 sccm and the Ar at a flow rate of about 0 sccm, the NH₃ at a flow rate of about 70 sccm, the C₄F₈ at a flow rate of about 25 sccm, and the CH₂F₂ at a flow rate of about 20 sccm. In these embodiments the gas mixture is applied at a pressure of about 40 mtorr. These embodiments can further include applying an over-etch gas mixture, wherein the over-etch gas mixture comprises applying a gas mixture comprising C₄F₆, N₂ and Ar.

In additional embodiments, the present invention is a plasma etching tool having a chamber capable of receiving a wafer. The chamber contains a gas mixture comprising CF₄, N₂ and Ar, and has a high density and low bombardment energy plasma formed within the chamber for etching a wafer.

The invention is also directed to an apparatus for carrying out the disclosed methods and including apparatus parts for performing each described method steps. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus.

Embodiments of the present invention are shown in the figures and will be described in more detail below. Therein:
FIGS. 1A-F are side views of an etching process in accordance with at least one embodiment of the present invention.
FIGS. 2A-D are flow charts of etching methods in accordance with embodiments of the present invention.
FIGS. 3A-C are side views of an etching process in accordance with at least one embodiment of the present invention.
FIG. 4 is a side view of a structure in accordance with at least one embodiment of the present invention.
FIGS. 5A and B are side views of structures in accordance with at least one embodiment of the present invention.
FIGS. 6A and B are side views of structures in accordance with at least one embodiment of the present invention.
FIGS. 7A and B are side views of structures in accordance with at least one embodiment of the present invention.
FIGS. 8A and B are side views of structures in accordance with at least one embodiment of the present invention.
FIGS. 9A and B are side views of structures in accordance with at least one embodiment of the present invention.
FIGS. 10A and B are side views of structures in accordance with at least one embodiment of the present invention.
FIGS. 11A and B are side views of structures in accordance with at least one embodiment of the present invention.
FIGS. 12A and B are side views of structures in accordance with at least one embodiment of the present invention.
FIGS. 13A and B are side views of structures in accordance with at least one embodiment of the present invention.
FIGS. 14A and B are side views of structures in accordance with at least one embodiment of the present invention.

In at least one embodiment, the present invention is a method of etching features into a material layer of a structure at high etch rates, achieving certain desired etch profiles, while having acceptable selectivity with other layers of the structure.

In at least some embodiments, the present invention is a plasma etching method which includes applying a gas mixture comprising CF₄, N₂ and Ar and forming a high density and low bombardment energy plasma. The high density and low bombardment energy plasma is formed by using high source and low bias power settings. The gas mixture can further include H₂, NH₃, a hydrofluorocarbon gas and/or a fluorocarbon gas. The hydrofluorocarbon gas can include CH₂F₂, CH₃F; and/or CHF₃. The fluorocarbon gas can include C₄F₈, C₄F₆ and/or C₅F₈.

In certain embodiments, the Applicant's invention employs high source and low bombardment levels to achieve high etch rates while maintaining desired feature profiles. The high source, i.e. high density, provides the increased etch rates, which, in at least certain examples, have been in the range of between about 9000 Angstroms per min, or Å/min, and about 20000 Å/min, for dielectric etches. These etch rates are high relative to more typical etch rates of about 6000 Å/min to 7000 Å/min for somewhat similar etch profile results. Of course, higher etch rates allow for reduced process times and increased production capacity for a given quantity of etch tooling. The lower bombardment, i.e. low bias, levels provide improve profiles by reducing, or eliminating, the amount and severity of any striation which might form about the etched features. Reducing striation is important as the newer photoresist materials tend to be very weak and thinner to allow for the formation of smaller features.

With certain embodiments of the present invention, the shape of the etch profile of the formed feature can further be improved, or tuned, by the addition of various gases in different embodiments of the invention. For example, hydrogen containing gases are used, in embodiments of the present invention, to control various factors of the etch including the etch rate and the profile. In some embodiments, hydrogen (H₂) gas is used during the etch to reduce the taper of the profile while maintaining some selectivity to a bottom barrier in the etched structure. In other embodiments, an ammonia (NH₃) gas is used to reduce tapering of the profile with low selectivity to bottom barrier. In still other embodiments, difluoromethane (CH₂F₂) gas is used to increase the etch rate, with a somewhat tapered profile. Other gases which can be used with the present invention include octafluorocyclobutane (C₄F₈), hexafluorobutadien (C₄F₆), C₅F₈, C₅F₈O and/or various combinations of these above listed gases.

Selectivity to other layers of the structure during the etch can be increased with embodiments of the present invention by the use of various gases during the etch. The use of very polymerizing gases allow the selectivity to other material layers to be increased. Lean gases, i.e. those that do not generate an excessive amount of polymer, can be used in combination with high source to provide higher selectivity. For example, lower carbon containing gases, such as tetrafluoromethane (CF₄) allow the increase in the source power to obtain an increase in the photoresist selectivity during the etch of a dielectric material layer. Low selectivity to the photoresist layer (e.g. a selectivity below about 5) can be a cause of striation in the photoresist layer. Another layer that high selectivity is desired is a barrier layer (if present in the structure), which is typically set below the dielectric layer to be etched.

Embodiments of the present invention can be used in any of a variety of different fabrication processes where etching is employed. That is, embodiments of the Applicant's methods can be performed on a variety of different materials, environments, process steps and settings. As detailed herein, some applications of various embodiments of the present invention can include use in a damascene or dual damascene processes. In such processes, embodiments of the invention can be applied during the etch of the inter-layer dielectric (ILD), inter-metal dielectric (IMD), or like material, to increase the etch rate while achieving a desired level of product quality. Specifically, the present invention can be used to form an OSG via and/or trench features in ILD, IMD or similar such layers, allowing multilevel interconnect structures in semiconductor integrated circuits to be fabricated.

In recent years dual damascene processes have been employed to increase the performance of integrated circuits. The standard aluminum and silicon oxide interconnect structures have been replaced by copper and low k dielectric materials using dual damascene patterning techniques. The use of dual damascene patterning techniques are typically done during the back-end processing, where the interconnections between devices and components are formed.

Until relatively recently, the back-end processing typically involved using a combination of tungsten plugs and aluminum interconnections. Generally, the aluminum was deposited over a certain region and then selectively etched to define the desired interconnections. However, with a desire to further increase performance, more recently materials with higher conductivities, such as copper, have begun to be used for the interconnects. While the use of copper provides many benefits, it does not allow for forming to be by etching as was done with aluminum.

As a result, fabrication processes were developed to allow deposition of copper without need for a copper etching step. In damascene and dual damascene processes, features, such as vias and trenches, are defined in a first material and then a second material is deposited into these features. The etched first material typically is a dielectric and the deposited second material is a metal, such as copper. Additional layers can be added by a CMP planarization process which provides a deposition surface for forming the next layer. As a result, such a process allows copper interconnections to be selectively formed in one or more layers, without the need to etch the copper.

Employing an interconnect material (copper) having a lower electrical resistance with an insulating material positioned between the interconnects, can result in increased capacitance being formed between the interconnect structures (layers). This increased capacitance can adversely effect performance of the device by decreasing the signal transport speed of the interconnects.

By reducing the dielectric constant (k) of the material positioned between the interconnects, the capacitance effects can be reduced and the signal transport speed restored or even increased over that obtained with aluminum interconnects. Low-k dielectrics have included carbon doped silicon dioxide and other like materials. The high carbon content of these low-k materials tend to cause them to be difficult to etch as the high amount of carbon byproduct or residue produced during etching can interfere with the etch as it progresses. Added to such interference can be adverse effects of residue or scum produced by the use of deep ultraviolet (DUV) photoresists.

As set forth in detail herein, embodiments of the present invention can be applied to the etch of low-k dielectrics including processes wherein DUV photoresists are used. Embodiments of the Applicant's invention provide an increase in the etch rate of the dielectric, without incurring the adverse effects from residue formation.

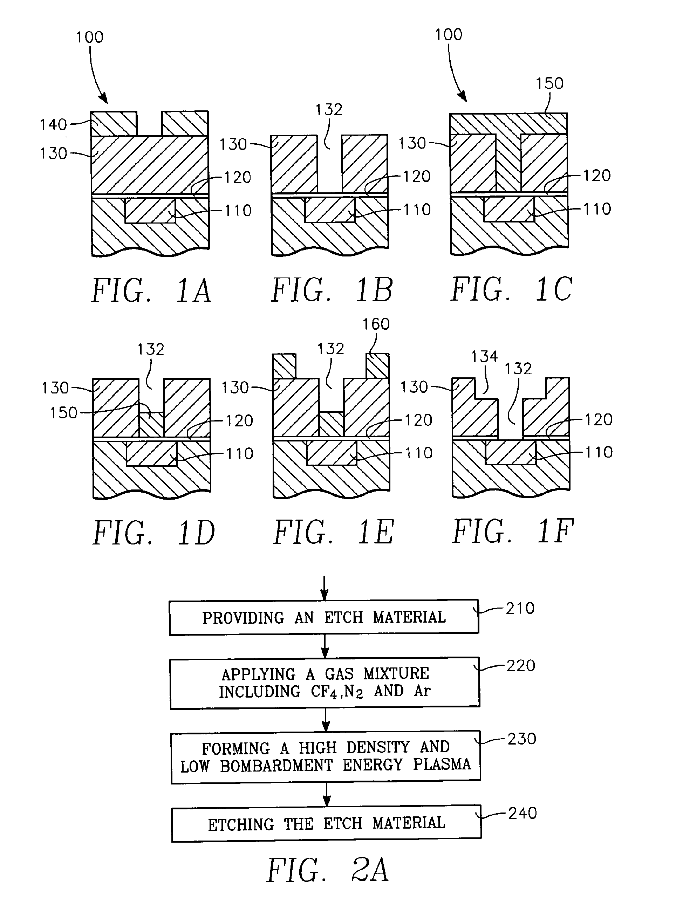

An example of a dual damascene process is set forth in Figures 1A-F. As shown the structure or wafer 100 includes a line 110, a barrier layer 120, an interlayer dielectric or ILD layer 130, and a patterned photoresist 140, as shown in Figure 1A. Figure 1B shows that after deposition of the ILD layer 130, a via 132 is patterned in the ILD layer 130. Then, after the via etch and striping of the photoresist 140 in a dielectric etch reactor, the wafer 100 is cleaned and a bottom anti-reflective coating or BARC 150 or resist is spun on the wafer 100, as shown in Figure 1C. Then, as shown in Figure 1D and E, the wafer 100 is etched back in the plasma reactor and sent back to trench lithography to apply a patterned photoresist layer 160. Finally, as shown in Figure 1F, a trench 134 is opened, resist 160 and BARC/Resist 150 fill is stripped, and the barrier 120 is opened in the dielectric etch reactor. Depending on the embodiment, the present invention can be applied to the first step of the dual damascene process, that is shown between Figures 1A and 1B, wherein the ILD layer 130 is etched.

Specific examples of applications of the present invention include etching an Organo-Silicate Glass, or OSG, low-k dielectric. Where the OSG can be a low-k film used, for example, in 90nm and below processes. Clearly, this patterning process can be applied to any low-k OSG porous and non porous film. Of course, application of the process of the present invention is not limited to dual damascene structures or to OSG etching.

### ETCH WITH CF₄/N₂/Ar GAS MIXTURE - BASE PROCESS:

Embodiments of the present invention utilize a high etch rate base process which employs during a main etch a gas mixture containing tetrafluoromethane (CF₄), nitrogen (N₂) and argon (Ar).

As shown in Figure 2A, a fabrication method 200 incorporating this base process can include the steps of providing an etch material 210, applying a gas mixture including CF₄, N₂ and Ar 220, forming a medium to high density and low bombardment energy plasma 230, and etching the etch material 240. As detailed herein, each of these steps can include one or more sub-steps and/or be performed at a variety of different particular values, or range of values, of several different variables.

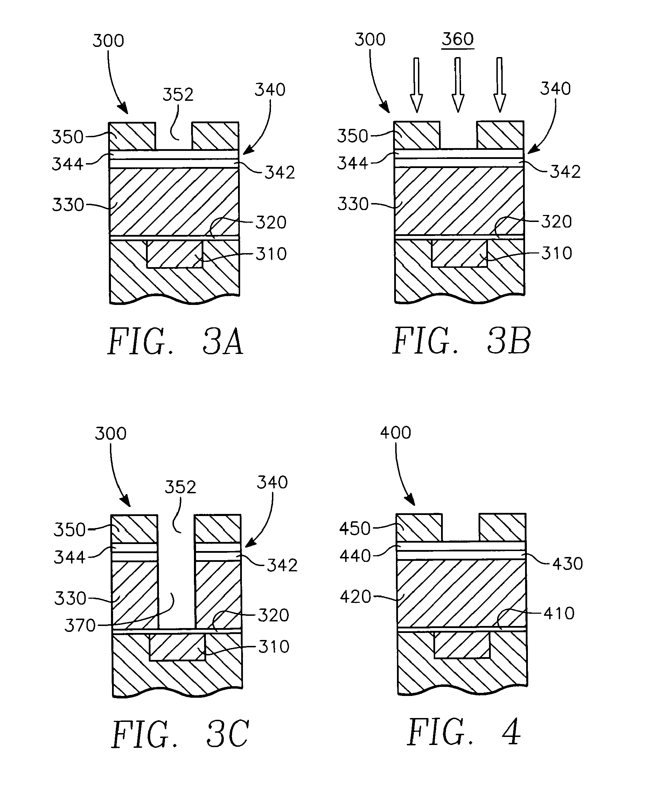

The initial step of the method 200 is providing an etch material 210. This step is shown with at least one embodiment, in a structure of Figure 3A.

Any of a variety of different materials can be etched by the method 200. In certain embodiments of the present invention, the etch is performed on dielectric materials. As previously noted, etching low-k dielectrics with the method provides certain advantages including a faster rate of etching and improved etch results including straighter profiles reduced striation and less residue build up. Such low-k dielectrics are those having a lower dielectric constant (k) relative to other known dielectric materials, such as SiO. These low-k values can be in the range of 2.0 to 3.7. Some particular examples of such low-k dielectric materials are described herein. These materials can be used in a variety of different applications including as Inter-Layer Dielectrics (ILD) and Inter-Metal Dielectrics (IMD).

Figure 3A shows one embodiment of a thin film structure 300 which can be etched by the method 200. Namely, the figure shows a cross-section of the structure 300 having a line 310, a barrier layer 320 positioned above the line 310, a dielectric layer 330 upon the barrier 320, an anti-reflective coating (ARC) 340 over the dielectric layer 330, and a photoresist layer 350 on the ARC 340.

The photoresist 350 can, as shown, be patterned to define a gap 352 that extends down to, and exposes a portion of, the anti-reflective coating 340. The gap 352 formed by any of a variety of known photoresist patterning techniques including photolithography. The gap 352 allows for selective etching of the anti-reflective coating 340 and the dielectric layer 330, as shown in Figure 3C. Typical thicknesses for a photoresist layer are between about 1500 Å and about 7000 Å, depending on the specific material and application.

As shown in Figure 3A, the anti-reflective coating 340 can include more than one layer, here with a bottom anti-reflective or BARC layer 342 and a dielectric anti-reflective or DARC layer 344. The BARC layer 342 can be any of a variety of materials. The DARC layer 344 can be a SiON or SiO₂ material. Typical thickness for a BARC layer is about 700 Å, and for a DARC layer about 750 Å, depending on the specific material and application. The anti-reflective coating 340 can include either one or both of the BARC 342 and the DARC 344 depending on the particular embodiment.

The dielectric layer 330 can be of a variety of materials such as a SiOC or an OSG. One example of a usable OSG is Black Diamond S, which is available from Applied Materials, Inc. of San Jose, California. Other usable dielectric materials include a silicon oxide doped with carbon and porous OSG deposited using CVD or spin-on techniques. Typical thickness for a dielectric layer is about 5000 Å, depending on the specific material and application.

The barrier layer 320 can be a SiCN or SiC material such as BloK or BloK II, which are available from Applied Materials, Inc. of San Jose, California. Other usable barrier layer materials include: SiCN and Si₃N₄. Typical thickness for a barrier layer is about 600 Å, depending on the specific material and application.

The line 310 can be a metal line, such as copper, aluminum, tungsten or platinum.

The etch material can be provided into an etching chamber or plasma furnace to facilitate additional steps of the method. Examples of usable etching tools are described herein.

Another step of the method 200 is applying a gas mixture 220, as shown in the flow chart of Figure 2A and a structural embodiment in Figure 3B.

Depending on the particular embodiment of the invention, the amount of each gas in the gas mixture can vary. That is, the flow rates of each of these gases can vary within a range over different embodiments of the method 200, and during particular portions of the etch processes. For example, the types and the amounts of gases used during an initial, breakthrough or open etch of the arc coating vary greatly from those used during a main etch (ME) of the dielectric. In certain embodiments, the amount of CF₄ used in the open etch is much greater than the amount of CF₄ used in the main etch. The open etch of the BARC/DARC can also be referred to as the arc etch, arc open etch, or in embodiments having just a BARC layer, as a BARC open etch. The main etch can be an etch of an ILD or IMD layer, producing any of a variety of features including vias and trenches.

The range of the flow rate of CF₄ is for the arc open etch is between 50 standard cubic centimeters per minute, or sccm, and 400 sccm. During the main etch, the CF₄ can be set between 20 sccm and 200 sccm. As further detailed herein, in certain embodiments of the method, the arc open etch is performed with a flow rate of CF₄ at, or about, 150 sccm and the main etch with a CF₄ flow rate at, or about, 65 sccm.

The arc open etch also uses trifluoromethane (CHF₃) gas during the etch. During the arc open etch, the CHF₃ can be set between 0 sccm and 400 sccm. As further detailed herein, in certain embodiments of the method, the arc open etch is performed with a flow rate of CHF₃ at, or about, 30 sccm.

For the nitrogen gas the range of the flow rate during the arc open etch is from 0 sccm to 400 sccm, and for the main etch between 0 sccm and 500 sccm. Particular embodiments have an arc open etch flow rate of, at or about, 0 sccm and a main etch flow rate of at, or about, 170 sccm.

The argon gas flow rate during the arc open etch can range from 0 sccm to 400 sccm, and for the main etch from 0 sccm to 2000 sccm. Certain embodiments have the arc open etch at, or about, 0 sccm and at, or about, 500 sccm for the main etch.

The pressure which the gas mixture is at can also range in value depending on both the embodiment of the fabrication method and the etch that is being performed. With the CF₄/N₂/Ar gas mixture, the pressure during the arc open etch can range from 30 millitorr, or mT, to 400 mT, and during the main etch from 5 mtorr (1 torr = 133,322 Pa) to 80 mtorr. In certain embodiments, the pressure is set at, or about, 300 mtorr for the arc open etch, and at, or about, 30 mtorr for the main etch.

The pressure ranges and values set forth above are for a wafer sized at 300 mm in diameter, for wafers of other sizes the values would be adjusted accordingly. For 200 mm wafer the pressure will be the same as for a 300 mm wafer. For example, the pressure settings for a 200 mm diameter wafer will be for the main etch of about 50 mtorr.

During the applying gas step 220 of the method 200, the gases can be applied either as a preformed mix of the gas components (such as CF₄/N₂/Ar), as a partial mixture of more than one component, or as individual components to mix in the chamber. One or more flows of gases, i.e. a double flow, can be employed to deliver the gases. Mixing the gases prior to being introduced into the chamber allows a showerhead, or similar device, to be used.

Figure 3B shows an embodiment of the structure 300 which can be etched by the present invention. As shown, a region 360 is defined above and about the structure 300. The gas mixture of CF₄/N₂/Ar, as described herein, can be applied adjacent etch material structure 300 in the region 360 during the applying step 220.

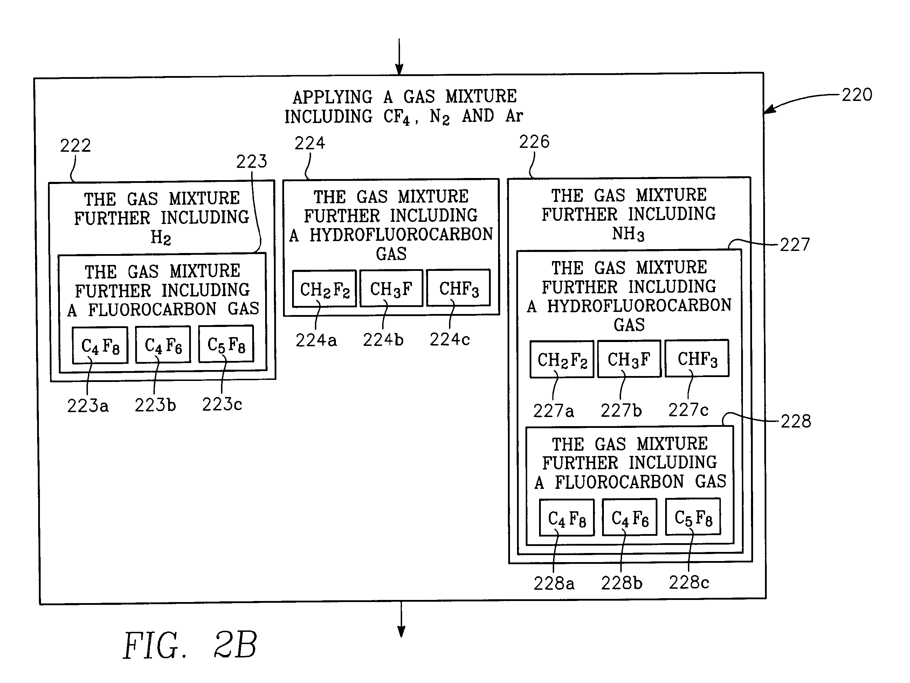

The flow chart of Figure 2B shows the step of applying a gas mixture including CF₄, N₂ and Ar 220, can include applying additional gases to the gas mixture. Namely, the applying step 220 can have the gas mixture further including H₂ 222, or the gas mixture further including a fluorocarbon gas 223. As shown with 223a-c, respectfully, the fluorocarbon gas can include C₄F₈, C₄F₆ and/or C₅F₈. Additionally, the step 220 can include applying the gas mixture further including a hydrofluorocarbon gas 224. Also, as shown with 224a-c, the hydrofluorocarbon gas can include CH₂F₂, CH₃F, and/or CHF₃. The applying step 220 can also have the gas mixture further including NH₃ 226. The addition of NH₃ can also include the gas mixture further including a hydrofluorocarbon gas 227, where as shown in 227a-c, respectfully, the hydrofluorocarbon gas can include CH₂F₂, CH₃F, and/or CHF₃. Likewise, adding NH₃ can include the gas mixture further including a fluorocarbon 228, where as shown in 228a-c, respectfully, the fluorocarbon gas can include C₄F₈, C₄F₆ and/or C₅F₈.

The step of forming a medium to high density and low bombardment energy plasma 230 of the fabrication method 200 is set forth in Figure 2A. The high density is achieved by using levels of source power which are high relative to those levels employed in known fabrication techniques. The density or electron density, can, depending on the embodiment, range from about 5x10¹⁰ electrons/cm³ and above, including about 1x10¹¹ electrons/cm³ and above. Of course, other ranges of the electron density are also usable. The low bombardment energy is obtained by using bias settings that are lower than those utilized in known techniques.

The particular level or range of levels that the source power and bias can be set at, as described herein, are dependent on the size of the wafer used. The greater the diameter of the wafer, the greater the Bias. The greater the volume of the chamber, the greater the Source. The ranges and values set forth below are for a wafer sized at 300 mm in diameter, for wafers of other sizes the values would be adjusted accordingly. For example, the bias settings for a 200 mm diameter wafer will about half of the values used for 300 mm wafers, but the source would be generally similar between a 200 mm wafer and a 300 mm wafer.

In these embodiments of the present invention, the source power can be set during the arc open etch from 0 Watts to 300 Watts, with certain embodiments of the method having a level at, or about 0 Watts. The main etch source power settings can be within the range of 0 Watts and 2000 Watts, where certain embodiments perform the main etch at, or about, 1000 Watts or at, or about, 1500 Watts.

The bias can be set for the arc open etch between 300 Watts and 2500 Watts, and for the main etch from 1000 Watts to 3000 Watts. Particular embodiments have more defined values, for example, certain embodiments have a bias of 2000 Watts during the arc open etch and 2800 Watts during the main etch. For embodiments with 200 mm wafers during the main etch, the bias power can be between 500 Watts and 1500 Watts, with certain embodiments having a bias of 1400 Watts.

Any of a variety of etching tools can be used to etch according to one or more embodiments of the present invention, including a dual frequency enabler or a dielectric etch enabler. Examples of usable tools include the Applied Centura Enabler Etch and the Applied Producer Etch, which are each available from Applied Materials, Inc. of San Jose, CA. Usable tools include that set forth in U.S. Patent Application Number 10/192,271, entitled CAPACITIVELY COUPLED PLASMA REACTOR WITH MAGNETIC CONTROL, by Hoffman et al., filed July 9, 2002, which is hereby incorporated by reference in its entirety.

Of course, similar tools manufactured by Applied Materials or other manufacturers can be used as well. Typically, the tool used will have to be tuned to account for the differences from the tools set forth herein, and to account for factors including the particular bias and source frequencies of the tool, wafer size and the like. Also, the chemistries may have to be adjusted depending on the specific volume of the chamber. Such tuning and adjustments can be made by one skilled in the art.

Each of the particular etching tools available from Applied Materials, as listed above, have controls including a Neutral Species Tuning Unit or NSTU, and a Charged Species Tuning Unit or CSTU. The NSTU and CSTU controls are used for uniformity tuning, which, among other things, allow independent control of etch rate and critical dimension, or CD, uniformities. The CSTU includes inner (I) and outer (o) settings that control the etch rate uniformity, while the NSTU sets the flow pattern of the gases, i.e. from a showerhead in the chamber. Being able to set the pattern of the flow allows more uniformity in the process. The gases of the gas mixture can be mixed prior to being distributed by the showerhead.

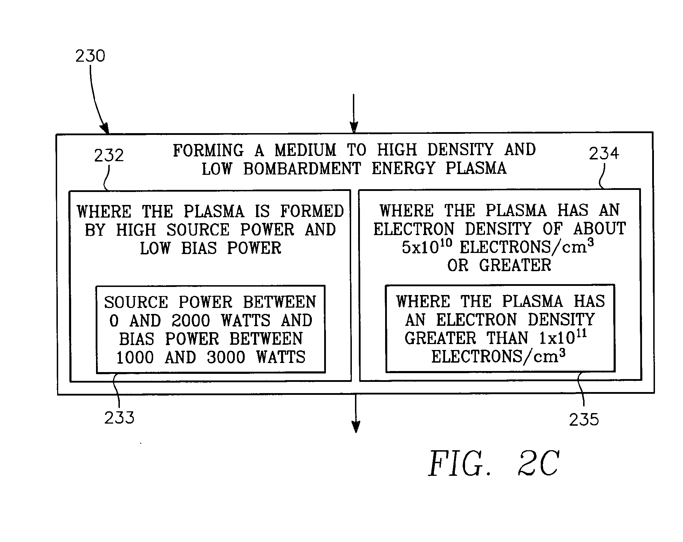

As shown in the flowchart of Figure 2C, the step of forming a medium to high density and low bombardment energy plasma 230 can include where the plasma is formed by high source power and low bias power 232, and where the plasma has an electron density of about 5x10¹⁰ electrons/cm³ or greater 234. The step 232 can further include the source power between 0 Watts and 2000 Watts and the bias power between 1000 Watts and 3000 Watts 233. Also, the step 234 can include where the plasma has an electron density greater than 1x10¹¹ electrons/cm³ 235.

As shown in Figures 2A and 3C, in at least one embodiment of the structure, another step in the method 200 is etching the etch material 240. During this step an opening is defined in the etch material at a high etch rate by using high source and low bias settings and a gas mixture containing tetrafluoromethane, nitrogen and argon.

Factors including the etch rate, duration of etch, depth and profile of the etched opening, selectivity and etch stop, can vary depending on the particular embodiment of the method. That is, the particular value and/or range of these factors will vary depending on items including the particular dielectric employed, type (if any) of anti-reflective coating, the source power levels, the bias power levels, the composition and concentrations of the gas mixture, the wafer diameter, and the like.

However, certain ranges and values of these factors can result from the application of embodiments of this step of the present method 200. For instance, generally, the etch rate during the etching step can be between 7000 Å/min and 12000 Å/min. In some embodiments, such as that shown in Example 1 herein, the etch rate can be about 9000 Å/min.

Likewise, the duration of the etch can vary depending on the embodiment of the method 200. Typically, the duration ranges from about 10 seconds to about 60 seconds. Certain embodiments have a duration of about 35 seconds for the arc open etch and about 30 seconds for the main etch.

The resulting depth and profile of the opening creating by the etch can vary depending on the embodiment. For example, the opening may be made deeper for a via, or wider for a trench, and in some circumstances have slanted or vertical sidewalls. While it is typically desired to minimize, or eliminate the taper of the vias, taper in the trench profile is typically not an issue as trenches are usually used to electrically isolate the die region and not normally for an interconnect.

Selectively of the etch can vary as well depending on the embodiments. The selectivity of the etch rate of the dielectric to the etch rate of the photoresist can range between 3 and 7. In certain situations the photoresist selectivity is approximately 5.

Figure 3C shows an embodiment of the structure 300, which can be etched by a embodiment of the method of present invention. As shown, an opening 370 has been formed in the structure 300. The opening 370 is position extending downward from the gap 352, through the anti-reflective layer 340 and into the dielectric material 330. The specific size (e.g. depth) and shape of the resulting opening 370 is dependent on various factors including, the size and position of the photoresist gap 352, the type of anti-reflective coating 340 and dielectric 330, the source power levels, the bias power levels, the gas mixture, and the duration of the etching. Depending on the particular application, the opening 370 can be formed into any of a variety of configurations including a via or a trench.

It should be noted that in some embodiments the gas mixture can include an inert gas selected from a group including He, Ne, Kr, Xe and Ar, and the like. The fluorocarbon gas can be a gas from a group including CF₄, C₂F₂, C₂F₄, C₃F₆, C₄F₆, C₄F₈ and C₆F₆, and the like. The hydrofluorocarbon gas can be a gas from a group including C₂HF₅, CHF₃, CH₃F, C₃H₂F₆, C₃H₂F₄, C₃HF₅, C₃HF₇, and the like.

### EXAMPLE 1:

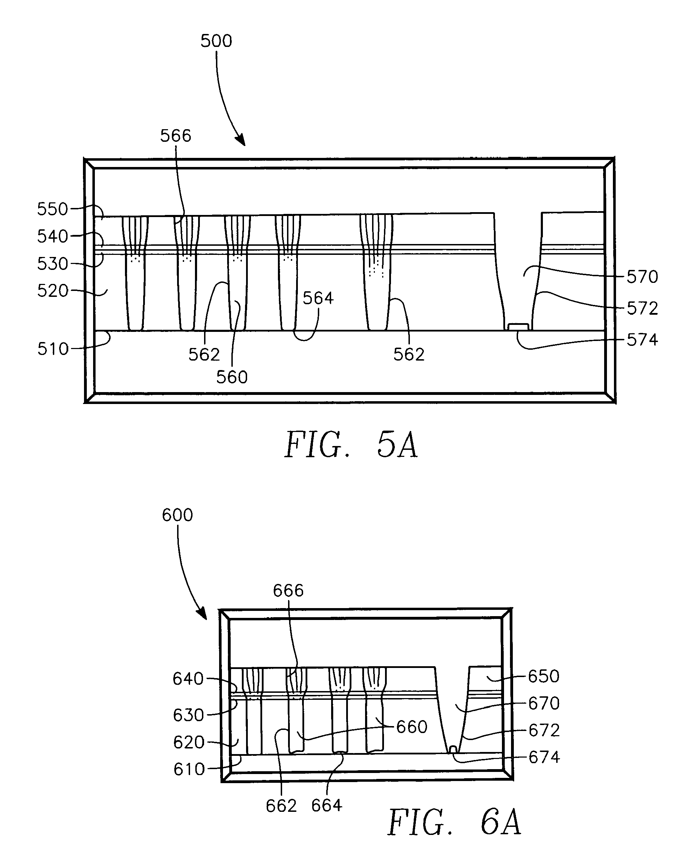

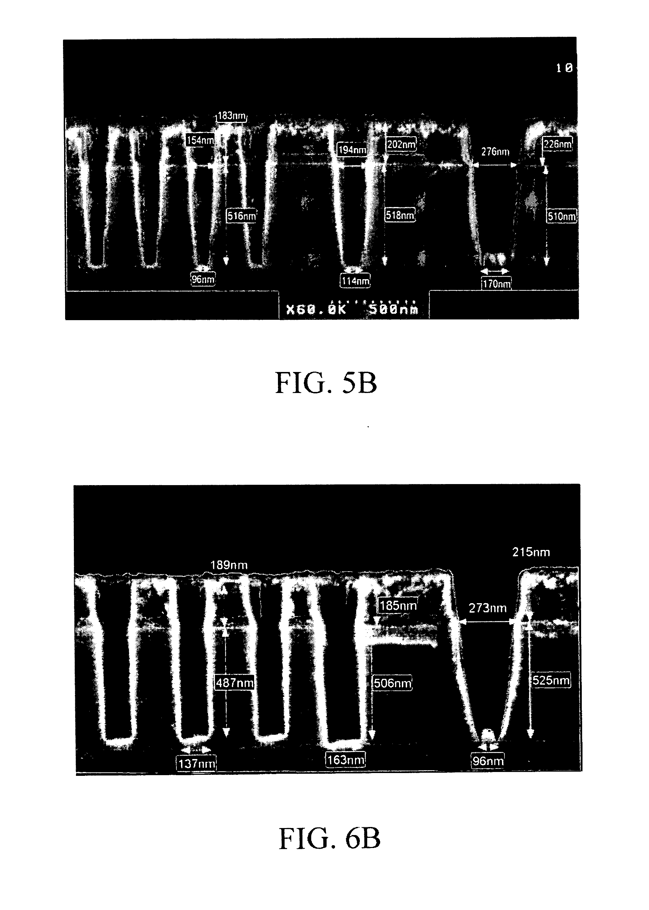

One example of an embodiment of the present invention includes etching at a rate greater than 9000 Å/min with high source and low bias settings and a gas mixture containing tetrafluoromethane, nitrogen and argon. A 300 mm diameter wafer is used in this example. An etched structure resulting from this example is shown in the cross-section of Figures 5A and B.

The first step of the etching process of Example 1 is to provide a structure to be etched. As shown in Figure 4, an etch structure 400 of this example includes a barrier layer 410, an inter-level dielectric (ILD) layer 420 position above the barrier layer 410, a dielectric anti-reflective layer (DARC) 430 over the ILD layer 420, a bottom anti-reflective layer (BARC) 440 on the DARC layer 430, and a photoresist layer (PR) 450 on top of the BARC layer 440.

In this particular example the barrier layer 410 is a BloK II (SiC), as described above, which functions as an etch stop. The dielectric material of the ILD layer 420 is Black Diamond S, as described above. The BARC layer 440 and the DARC layer 430 are standard organic anti-reflective layers. Namely, the BARC is Brewer ARC 29A available from Brewer of Rolla, Missouri and the DARC is SiON available from Applied Materials of San Jose, CA. The BARC and DARC are deposited on the ILD layer 420 to reduce reflections during the lithography exposure. The photoresist used is TOK7A7O a 193 nm photoresist, which is available from TOK, Tokyo Ohka Kogyo Co., Ltd. of Kawasaki City, Japan.

In this example the unetched structure is positioned in a Applied Centura Enabler Etch tool, which is described above. With the layered etch structure positioned in the reactor, the etching is then performed.

This example of the invention has a two part etching process that includes an arc etch followed by a main etch. The two part etch allows for the etching to be tailored to the particular material, or materials, being etched. During the arc etch the BARC layer 440 and the DARC layer 430 are each etched through at the various openings defined in the photoresist layer 450. During the main etch the ILD layer is etched. The main etch can terminate at the barrier layer 410.

To start each stage of etching, the first step is to apply the gas mixture at the concentrations of gases set forth herein. For the arc etch, the gas mixture includes 150 sccm of CF₄ and 30 sccm of CHF₃ at a pressure of 300 mtorr. This mixture is changed for the main etch during which the gas mixture includes 65 sccm of CF₄, 170 sccm of N₂ and 500 sccm of Ar, at a pressure of 30 mtorr.

With the gas applied, the next step is to form a plasma. The plasma formed for the arc etch has the bias at 2000 Watts and the source at 0 Watts. The Applied Centura Enabler Etch tool has the NSTU set at 1.35, the CSTU inner/outer (i/o) set at 4/0, and the wafer/chuck cooling Helium (He) inner/outer (in-out) pressures are 10torr-10torr. For the main etch, the bias is 2800 Watts and the source is 1000 Watts, the reactor has the NSTU set at 4, the CSTU i/o set at 0/7, and the He in-out pressures at 15torr-15torr.

Once the plasma is formed for each of the etching stages, the structures are etched for different durations. In this example, the arc etch was performed for 35 seconds, with the conditions listed above, and the main etch for 30 seconds, with its respective conditions.

The results of the arc etch and the main etch for this example are shown in Figures 5A and B. As shown in Figure 5A, a structure 500 has been etched to define vias 560 and a trench 570. The structure 500 includes a barrier layer 510, an ILD layer 520 is position above the barrier layer 510, a DARC layer 530 is over the ILD layer 520, a BARC layer 540 is on the DARC layer 530, and a PR layer 550 is on top of the BARC layer 540.

In this example, the Black Diamond etch rate, or BD etch rate, is measured at greater than 9000 Å/min, which is an increase from the typical results of approximately 5500 Å/min for other processes. During the main etch, the photoresist is etched at a measured rate of about 1800 Å/min, resulting in a photoresist selectivity (BD etch rate to PR etch rate) of about 5. This selectivity is an increase compared to the typical photoresist selectivity for other processes of about 3.

As shown in the example results of Figures 5A and B, the profile of the resulting vias and trench, have tapered shapes. Specifically, as shown in Figure 5A, the vias 560 have tapered sidewalls 562 and the trench 570 has tapered sidewalls 572. Also, the vias 560 may have, as shown, striations 566 at, or about, the PR layer 550. The vias 560 are shown with a bottom or stop 564 at, or about the barrier layer 510. Likewise, the trench 570 is shown with a bottom or stop 574 at, or about the barrier layer 510.

### ETCH WITH CF₄/N₂/Ar/H₂ GAS MIXTURE:

Another set of embodiments of the present invention also employ high source and low bias settings to achieve high etch rates, but with hydrogen (H₂) added to the gas mixture of the base process. The step of applying a gas mixture upon the etch material 220 of the method 200 uses a gas mixture containing tetrafluoromethane, nitrogen, argon and hydrogen. Figure 2B shows embodiments of the applying a gas mixture which can include H₂, as detailed herein.

An effect of adding hydrogen is that the profile or shape of the opening (e.g. via, trench) created during the etch, can be changed. This is because compared to the use of other gases, hydrogen tends to cause the etch to occur at a faster rate not only in the vertical direction, but also in the horizontal direction (relative to the vertical bias). As a result, the profile of the opening that is etched with hydrogen tends to have more vertical, i.e. less tapered, sidewalls. Forming such straight sidewalls allows for the formation of deeper openings with higher aspect ratios. As a result, a higher density of features and more interconnecting layers can be achieved. Also, the quality of the resulting device can be improved by reducing the potential for incomplete connections due to tapered profiles and premature etch stop. Hydrogen also has the effect of maintaining selectivity to the bottom barrier layer. Examples of forming etched vias and trenches having profiles with reduced taper, are set forth herein in Examples 2-4.

As noted above in the description of the base process, a variety of different materials and layers can be etched with the CF₄/N₂/Ar/H₂ gas mixture. One such usable structure is shown in Figure 3A.

Factors such as the types of gases, flow rates, source power and bias settings, chamber pressures, type of chamber, chamber settings, cooling, wafer size, etched material and layering, etch type, etch duration and the like, can include those set forth in detail above in the base process. Of course, the resulting etch rate, depth and profile of the etched opening, selectivity and etch stop, and other items, can vary depending on such factors and the particular application of these embodiments. For example, the specific size (e.g. depth) and shape of the resulting formed opening can depend on various factors such as the size and position of the photoresist gap, the type of anti-reflective coating and dielectric, the source power levels, the bias power levels, the gas mixture, the duration of the etching, and the like.

The flow rates and ranges of flow rates of the CF₄, N₂ and Ar for both the arc open and the main etches are as set forth above in the base process. The flow rate of the hydrogen gas used during the etch of the etch material can vary depending on the specific embodiment of the invention. The range of the hydrogen flow for the arc open etch can be from 0 sccm to 200 sccm, and for the main etch from 0 sccm to 200 sccm. In certain embodiments, the hydrogen is applied at, or about, 0 sccm for the arc open etch, and at, or about, 20 sccm for the main etch (as detailed herein in the embodiment of Examples 2-4).

The gases can be applied either as a preformed mix of the gas components), as a partial mixture of more than one component, or as individual components mixed in the chamber. Premixing allows application of the gas by means such as a showerhead.

In addition to the ranges set forth in the base process, in certain embodiments using the CF₄/N₂/Ar/H₂ gas mixture, the pressures can be set at, or about, 300 mtorr for the arc open etch and at, or about, 30 mtorr for the main etch. Also, in some embodiments, the source power can be at, or about 0 Watts, during the arc open etch and at, or about, 1500 Watts during the main etch, the bias can be at, or about, 2000 Watts during the arc open etch and at, or about, 2800 Watts during the main etch.

The resulting etch rates obtained with this process, can vary depending on the embodiment. As shown herein, by embodiments of the invention employing a CF₉/N₂/Ar/H₂ gas mixture, etch rates have been measured at about 9500 Å/min to at about, 9700 Å/min. In certain embodiments the etch duration is about 35 seconds for the arc open etch and about 20 seconds to 40 seconds for the main etch. Also, in some embodiments, the photoresist selectivity can be about 5 to 8.

### EXAMPLE 2:

Another example of an embodiment of the present invention includes etching at a rate of 9700 Å/min by using a high source and a low bias and a gas mixture which includes tetrafluoromethane, nitrogen, argon and hydrogen. A 300 mm diameter wafer is used in this example. A structure which was formed from this example is shown in cross-section in the Figures 6A and B.

The first step of the method of this example is to provide a structure that will be etched in the following steps. The arrangement of layers of structure used in this example the same as that of Figure 4, as described in Example 1 above.

An Applied Centura Enabler Etch tool is used to etch the structure 400. In this example a two part etching process, which includes an arc etch and then a main etch, is performed. The two part etch allows for the etching to be tailored to the particular material, or materials, being etched. During the arc etch, the BARC layer 440 and the DARC layer 430 are each etched through at each opening defined in the photoresist layer 450. Then, during the main etch the ILD layer 420 is etched. With the barrier layer 410 positioned below the ILD layer 420, the main etch may terminate at the barrier layer 410.

Both the arc etch and main etch include the step of applying the gas mixture at the concentrations and values as detailed herein. As described, different gases types and concentrations thereof are used for each etch.

For the arc etch, the gas mixture includes 150 sccm of CF₄ and 30 sccm of CHF₃ at a pressure of 300 mtorr. For the main etch, the mixture includes 65 sccm of CF₄, 170 sccm of N₂, 500 sccm of Ar and 20 sccm of H₂, at a pressure of 30 mtorr.

With the gas applied for each stage of the etch then the plasma is formed. The plasma formed for the arc etch has a bias of 2000 Watts and the source at 0 Watts. The Applied Centura Enabler Etch tool has the NSTU set at 1.35, the CSTU i/o set at 4/0, and the He in-out pressures are 10torr-10torr. For the main etch, the bias is 2800 Watts and the source is 1500 Watts, the reactor has the NSTU set at 4, the CSTU i/o set at 0/7, and the He in-out pressures at 15torr-15torr.

Once the plasma is formed for each of the etching stages, the structures are etched for different durations. In this example, for each set of the conditions as listed, the arc etch is performed for 35 seconds, and the main etch for 25 seconds.

The results of the arc etch and the main etch for this example are shown in Figures 6A and B. As shown in Figure 6A, a structure 600 has been etched to define vias 660 and a trench 670. The structure 600 includes a barrier layer 610, an ILD layer 620, a DARC layer 630, a BARC layer 640, and a PR layer 650.

In this example the BD etch rate is measured at 9700 Å/min, and the photoresist etch rate during the main etch is measured to be about 1900 Å/min. The resulting photoresist selectivity is about 5.1.

As shown in Figures 6A and B, the profile of the resulting vias and trench, tend to have more vertical or less tapered sidewalls. That is, cross-sections and widths of the openings tend to remain more constant over the depth of the vias and the trench. Specifically, as shown in Figure 6A, relative to the sidewalls of Example 1, in this example the vias 660 have reduced tapered sidewalls 662 and the trench 670 has less tapered sidewalls 672. The vias 660 have striations 666 at, or about, the PR layer 650. The vias 660 are shown with a bottom or stop 664 at, or about the barrier layer 610. Likewise, the trench 670 is shown with a bottom or stop 674 at, or about the barrier layer 610.

As such, it has been found in embodiments of the present invention that, for at least this example, the addition of hydrogen (H₂), with the high source/relative low bias etch processes, results in a high etch rate and photoresist selectivity, with profiles having sidewalls that are more vertical or less tapered in shape.

### EXAMPLE 3:

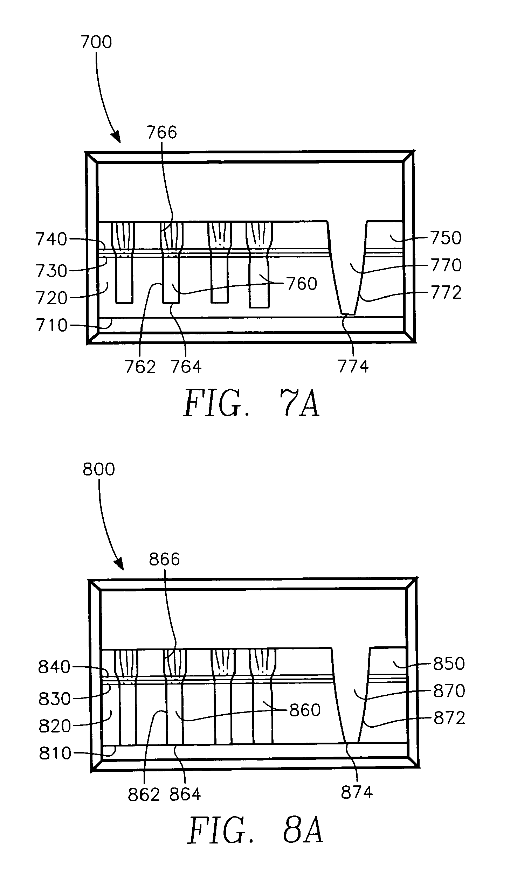

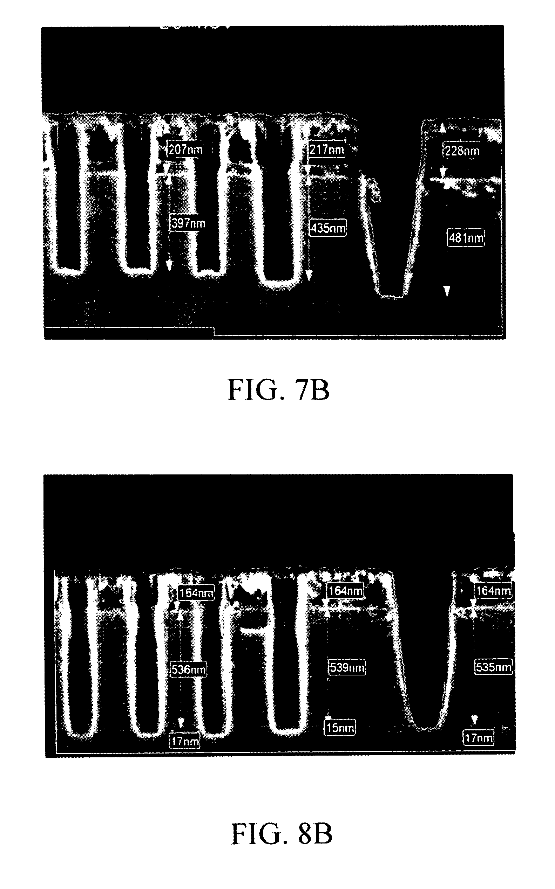

Another example of an embodiment of the present invention is an etching process that achieves an etch rate measured at greater than 9500 Å/min by using a high source and a low bias and a gas mixture which includes tetrafluoromethane (CF₄), nitrogen (N₂), argon (Ar) and hydrogen (H₂). While similar to that of Example 2, this example is different in that a shorter main etch time is used. Also, the etch ends before the vias or the trench reach the barrier layer. Again, here a 300 mm diameter wafer is used. Figures 7A and B show a cross-section of a structure formed by this example.

The arrangement of layer of structure used in this example the same as that of Figure 4, as described in Example 1 above.

An Applied Centura Enabler Etch tool, described above is used to etch the structure. The etching is two part, including the arc etch and then the main etch. During the arc etch, the BARC layer 440 and DARC layer 430 are each etched and during the main etch the ILD layer 420 is etched, where the etch may terminate at the barrier layer 410.

At the beginning of both the arc etch and the main etch, the gas mixture is applied at different concentrations and values. For the arc etch, the gas mixture includes 150 sccm of CF₄ and 30 sccm of CHF₃ at a pressure of 300 mtorr. For the main etch the mixture includes 65 sccm of CF₄, 170 sccm of N₂, 500 sccm of Ar, 20 sccm of H₂, at a pressure of 30 mtorr.

The next step for each etch is forming the plasma. For the arc etch the bias is 2000 Watts and the source is 0 Watts. The Applied Centura Enabler Etch tool has the NSTU set at 1.35, the CSTU i/o set at 4/0, and the He in-out pressures at 10torr-10torr. For the main etch, the bias is 2800 Watts and the source is 1500 Watts, the reactor has the NSTU set at 4, the CSTU i/o set at 0/7, and the He in-out pressures at 15torr-15torr.

Upon forming the plasma the structures are etched for different durations for each of the etching stages. In this example, for each set of the conditions as listed, the arc etch is performed for 35 seconds, and the main etch for 20 seconds.

Figures 7A and B set forth cross-sections of an etched structure after the arc and main etches in this example. As shown in Figure 7A, a structure 700 has been etched to define vias 760 and a trench 770. The structure 700 includes a barrier layer 710, an ILD layer 720, a DARC layer 730, a BARC layer 740, and a PR layer 750.

The BD etch rate is measured at greater than 9500 Å/min, and the photoresist etch rate during the main etch is measured to be about 1900 Å/min. The resulting photoresist selectivity is about 5.

Figures 7A and B show that the profiles of the formed vias are generally straight and the trench is tapered along its depth. Also, the etch stopped prior to reaching the etch stop layer. As shown in Figure 7A, the vias 760 have generally straight sidewalls 762 and the trench 770 has somewhat tapered sidewalls 772. The vias 760 have some striations 766 at, or about, the PR layer 750. The vias 760 are shown with a bottom or stop 764 above the barrier layer 710. Likewise, the trench 770 is shown with a bottom or stop 774 above the barrier layer 710.

Therefore, it has been found with embodiments of the present invention, that the addition of hydrogen (H₂) to the CF₄/N₂/Ar gas mixture, with the high source/relative low bias etch processes, for a reduced main etch duration of 20 seconds, results in a high etch rate, high photoresist selectivity, via sidewalls that are generally straight, tapered sidewall for the trench, and an etch stop prior to reaching the barrier layer. As noted below in Example 4, increasing the duration of the main etch can allow the etch to reach the barrier layer.

### EXAMPLE 4:

An example of an embodiment of the Applicants' invention is an etching process that achieves a high measured etch selectivity by using a high source and a low bias and a gas mixture which includes tetrafluoromethane (CF₄), nitrogen (N₂), argon (Ar) and hydrogen (H₂). While similar to that of Examples 2 and 3, this example is different in that a longer main etch duration is used. This longer main etch allows the vias and trench to reach the barrier layer and at least some etch of the barrier to occur. Again, here a 300 mm diameter wafer is used. Figures 8A and B show cross-sections of a structure formed by this example.

The arrangement of layers of structure used in this example the same as that of Figure 4 as described in Example 1 above.

An Applied Centura Enabler Etch tool, described above, is used to etch the structure. The etching is two part, including the arc etch and then the main etch. During the arc etch, the BARC layer 440 and the DARC layer 430, are each etched. During the main etch, the ILD layer 420 is etched, where the main etch may terminate at the barrier layer 410.

At the beginning of both the arc etch and the main etch, the gas mixture is applied at different concentrations and types of gases. For the arc etch, the gas mixture includes 150 sccm of CF₄ and 30 sccm of CHF₃ at a pressure of 300 mtorr. For the main etch the mixture includes 65 sccm of CF₄, 170 sccm of N₂, 500 sccm of Ar, 20 sccm of H₂, at a pressure of 30 mtorr.

The next step for each etch is forming the plasma. For the arc etch the bias is 2000 Watts and the source is 0 Watts. The Applied Centura Enabler Etch tool has the NSTU set at 1.35, the CSTU i/o set at 4/0, and the He in-out pressures are at 10torr-10torr. For the main etch, the bias is 2800 Watts and the source is 1500 Watts, the reactor has the NSTU set at 4, the CSTU i/o set at 0/7, and the He in-out pressures at 15torr-15torr.

Upon forming the plasma the structures are etched for different durations for each of the etching stages. In this example, for each set of the conditions as listed, the arc etch is performed for 35 seconds, and the main etch for 40 seconds.

Figures 8A and B set forth a cross-section of the etched structure after the arc and main etches in this example. As shown in Figure 8A, a structure 800 has been etched to define vias 860 and a trench 870. The structure 800 includes a barrier layer 810, an ILD layer 820, a DARC layer 830, a BARC layer 840, and a PR layer 850.

As with the etch of Example 2, in this example the BD etch rate is measured at 9700 Å/min, and the photoresist etch rate during the main etch is measured to be about 1900 Å/min. The resulting photoresist selectivity is about 5.1.

Also, because this example has a main etch for 40 seconds the BloK barrier is not only reached by the vias and the trench, but the BloK barrier is etched as well. The etch of the barrier layer allows the barrier selectivity (BD etch rate to BloK etch rate) to be determined. The measured BloK barrier selectivity is about 8 (with a greater selectivity in the trench area compared to that of the vias).

Figures 8A and B show that the sidewalls of the formed vias are generally straight and the vias and the trench extend to the barrier layer. The sidewalls of the trench are tapered, but less so than the sidewalls of Example 3. In Figure 8A, the vias 860 have generally straight sidewalls 862 and the trench 870 has somewhat tapered sidewalls 872. The vias 860 have some striations 866 at, or about, the PR layer 850. The vias 860 are shown with a bottom or stop 864 at the barrier layer 810. Likewise, the trench 870 is shown with a bottom or stop 874 at the barrier layer 810.

Therefore, it has been found with these embodiments of the invention, that the addition of hydrogen (H₂) to the CF₄/N₂/Ar gas mixture, with the high source/relative low bias etch processes, for a main etch duration of 40 seconds, results in a high etch selectivity to the photoresist and bottom barrier, via sidewalls that tend to be vertical, tapered sidewall for the trench, and an etch for the vias and trench that continues to and into the barrier layer.

### ETCH WITH CF₄/N₂/Ar/CH₂F₂ GAS MIXTURE:

Another set of embodiments of the present invention also employs high source and low bias settings to achieve high etch rates, but with a hydrofluorocarbon added to the gas mixture of the base process. In some embodiments the added hydrofluorocarbon is difluoromethane (CH₂F₂). For method 200, the step of applying a gas mixture upon the etch material 220 uses a gas mixture containing tetrafluoromethane, nitrogen, argon and difluoromethane, as shown in Figure 2B.

Effects of the addition of difluoromethane include a higher etch rate and a change in the profile of the opening created during the etch. This is because the difluoromethane tends to cause the etch to occur at a faster rate. As a result, the profile of the opening etched with the addition of difluoromethane, tends to be less tapered. That is, the sidewalls are more vertical with less of a inward taper. Forming more vertical sidewalls allows for the formation of deeper openings with higher aspect ratios. Which, in turn, allows for higher density, and more interconnect layers and higher quality structures. Difluoromethane also tends to produce more polymer and earlier etch stops. As a result the addition of other additional gases can sometimes be used to further improve the etch profile. An example of forming etched vias and trenches with the addition of difluoromethane is set forth herein in Example 5.

As noted above in the description of the base process, a variety of different materials and layers can be etched with a CF₄/N₂/Ar/CH₂F₂ gas mixture. One such usable structure is shown in Figure 3A.

Factors such as the types of gases, flow rates, source power and bias settings, chamber pressures, type of chamber, chamber settings, cooling, wafer size, etched material and layering, etch type, etch duration and the like, can include those set forth in detail in the base process. Of course, the resulting etch rate, depth and profile of the etched opening, selectivity and etch stop, and other items, can vary depending on such factors and the particular application of these embodiments. For example, the specific size (e.g. depth) and shape of the resulting formed opening can depend on various factors such as the size and position of the photoresist gap, the type of anti-reflective coating and dielectric, the source power levels, the bias power levels, the gas mixture, the duration of the etching, and the like.

The flow rates and ranges of flow rates of the CF₄, N₂ and Ar for both the arc open and the main etches are as set forth above in the base process. The flow rate of the difluoromethane can vary depending on the particular embodiment. During the arc open etch the difluoromethane can range from 0 sccm to 40 sccm, and from 0 sccm to 60 sccm for the main etch. In certain embodiments, the difluoromethane is applied at, or about, 0 sccm for the arc open etch, and at, or about, 10 sccm for the main etch, as detailed herein.

The gases can be applied either as a preformed mix of the gas components), as a partial mixture of more than one component, or as individual components mixed in the chamber. Premixing the gas allow application through means such as a showerhead.

In addition to the ranges set forth in the base process, in certain embodiments using the CF₄/N₂/Ar/CH₂F₂ gas mixture, the pressures can be set at, or about, 300 mtorr for the arc open etch and at, or about, 30 mtorr for the main etch. Also, in some embodiments, the source power can be at, or about 0 Watts, during the arc open etch and at, or about, 1500 Watts during the main etch, the bias can be at, or about, 2000 Watts during the arc open etch and at, or about, 2800 Watts during the main etch.

The resulting etch rates obtained with this process, can vary depending on the embodiment. As shown herein, etch rates measured at about 11000 Å/min have been achieved by embodiments employing a CF₄/N₂/Ar/CH₂F₂ gas mixture. In certain embodiments the etch duration is about 35 seconds for the arc open etch and about 20 seconds for the main etch. Also, with some embodiments, the photoresist selectivity can be approximately 5.

In separate embodiments of the present invention, hydrofluorocarbons, other than difluoromethane (CH₂F₂), can be used. These potential substitute hydrofluorocarbons include CH₃F and CHF₃, can be used in place of difluoromethane (CH₂F₂). The hydrofluorocarbon CH₃F will carry more polymer as it has more hydrogen, and CHF₃, which is very lean, is less effective in terms of increasing polymer.

### EXAMPLE 5:

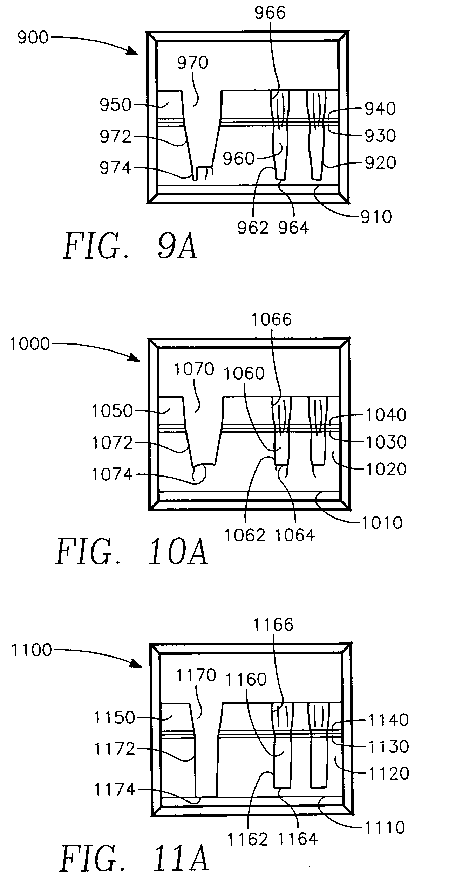

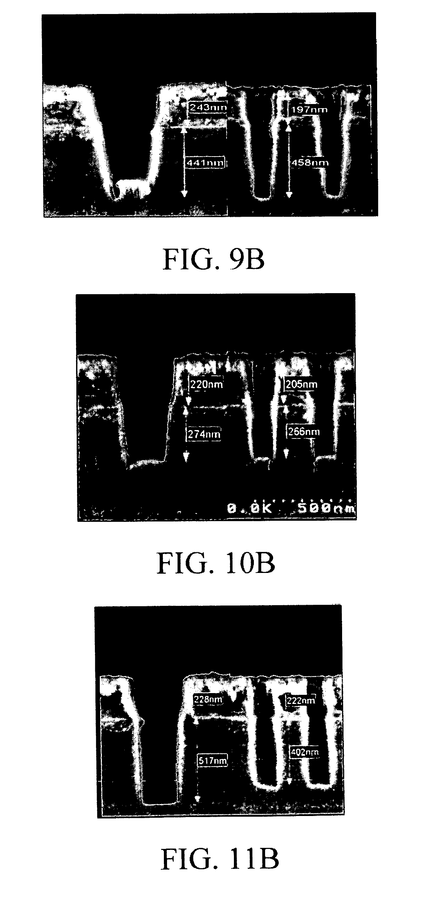

An example of an embodiment of the present invention is an etching process that achieves an etch rate measured at greater than 11000 Å/min by using a high source and a low bias and a gas mixture which includes tetrafluoromethane (CF₄), nitrogen (N₂), argon (Ar) and difluoromethane (CH₂F₂). A 300 mm diameter wafer is used in this example. A structure formed from operation of this example is shown in cross-section in Figures 9A and B.

The first step of the method of this example is to provide a structure that will be etched in the following steps. The arrangement of layers of structure used in this example the same as that of Figure 4, as described in Example 1 above.

An Applied Centura Enabler Etch tool is used to etch the structure. In this example a two part etching process, which includes an arc etch and then a main etch is preformed. The two part etch allows for the etching to be tailored to the particular material, or materials, being etched. During the arc etch, the BARC layer 440 and the DARC layer 430 are each etched through at the openings defined in the photoresist layer 450. Then, during the main etch, the ILD layer 420 is etched. With the barrier layer 410 positioned below the ILD layer 420, the main etch may terminate at the barrier layer 410.

At the beginning of both the arc etch and the main etch, the first step is to apply the gas mixture at the concentrations and types of gases. For the arc etch, the gas mixture includes 150 sccm of CF₄ and 30 sccm of CHF₃ at a pressure of 300 mtorr. For the main etch, the mixture includes 65 sccm of CF₄, 170 sccm of N₂, 500 sccm of Ar, and 10 sccm of CH₂F₂, at a pressure of 30 mtorr.

With the gas applied for each stage of the etch, the plasma is formed. The plasma formed for the arc etch has a bias of 2000 Watts and the source at 0 Watts. The Applied Centura Enabler Etch tool has the NSTU set at 1.35, the CSTU i/o set at 4/0, and the He in-out pressures at 10torr-10torr. For the main etch, the bias is 2800 Watts and the source is 1500 Watts, the reactor has the NSTU set at 4, the CSTU i/o set at 0/7, and the He in-out pressures at 15torr-15torr.

With the plasma formed for each of the etching stages, the structures are etched for different durations. In this example, for each set of the conditions as listed, the arc etch is performed for 35 seconds, and the main etch for 20 seconds.

Figures 9A and B set forth cross-sections of the etched structure after the arc and main etches in this example. As shown in Figure 9A, a structure 900 has been etched to define vias 960 and a trench 970. The structure 900 includes a barrier layer 910, an ILD layer 920, a DARC layer 930, a BARC layer 940, and a PR layer 950.

The BD etch rate is measured at greater than 11000 Å/min, and the photoresist etch rate during the main etch is measured to be about 2150 Å/min. The resulting photoresist selectivity is about 5.

As shown in Figures 9A and B, the profile of the formed vias and trench, tend to have tapered sidewalls, as their cross-sections and widths tend to decrease over their depth. In Figure 9A, the vias 960 have tapered sidewalls 962 and the trench 970 has tapered sidewalls 972. The vias 960 have some striations 966 at, or about, the PR layer 950. The vias 960 are shown with a bottom or stop 964, above the barrier layer 910. Likewise, the trench 970 is shown with a bottom or stop 974, above the barrier layer 910.

As such, it has been found with embodiments of the present invention, that the addition of difluoromethane (CH₂F₂), with the high source/relative low bias etch processes, results in a very high etch rate and high photoresist selectivity, with tapered profiles having slanted sidewalls.

### ETCH WITH CF₄/N₂/Ar/H₂/C₄F₈ GAS MIXTURE:

Additional embodiments of the Applicants' invention use the base process with the addition to the gas mixture of hydrogen (H₂) and a fluorocarbon. In some embodiments, the added fluorocarbon is octafluorocyclobutane (C₄F₈). The step of applying a gas mixture upon the etch material 220 of the method 200 uses a gas mixture containing tetrafluoromethane, nitrogen, argon, hydrogen and octafluorocyclobutane, as shown in Figure 2B.

The addition of hydrogen and octafluorocyclobutane allows for control of the taper of the profile of etched opening. Specifically, by using these gases the profile of the etched openings tend to have more vertical and/or less tapered sidewalls. Octafluorocyclobutane is a more polymerizing gas and because of the high levels of polymer tends to have early etch stop. An example of the etch with the addition of hydrogen and octafluorocyclobutane is set forth herein in Example 6.

As noted above in the description of the base process, a variety of different materials and layers can be etched with the CF₄/N₂/Ar/H₂/C₄F₈ gas mixture. One such usable structure is shown in Figure 3A.

Factors such as the types of gases, flow rates, source power and bias settings, chamber pressures, type of chamber, chamber settings, cooling, wafer size, etched material and layering, etch type, etch duration and the like, can include those set forth in detail in the base process. Of course, the resulting etch rate, depth and profile of the etched opening, selectivity and etch stop, and other items, can vary depending on such factors and the particular application of these embodiments. For example, the specific size (e.g. depth) and shape of the resulting formed opening can depend on various factors such as the size and position of the photoresist gap, the type of anti-reflective coating and dielectric, the source power levels, the bias power levels, the gas mixture, the duration of the etching, and the like.

The flow rates and ranges of flow rates of the CF₄, N₂ and Ar for both the arc open and the main etches are as set forth above in the base process. The amount of hydrogen gas used during the etch of the etch material can vary, with the specific amount used depending on the embodiment of the invention. During the arc open etch the hydrogen can range from 0 sccm to 200 sccm, and from 0 sccm to 200 sccm for main etch. In certain embodiments, the hydrogen is applied at, or about, 0 sccm for the arc open etch, and at, or about, 20 sccm for the main etch.

The amount of octafluorocyclobutane gas used during the etch of the etch material can vary depending on the embodiment of the method. During the arc open etch the octafluorocyclobutane can range from 0 sccm to 10 sccm, and from 0 sccm to 35 sccm for the main etch. In certain embodiments, the octafluorocyclobutane is applied at, or about, 0 sccm for the arc open etch, and at, or about, 10 sccm for the main etch.

The gases can be applied either as a preformed mix of the gas components, as a partial mixture of more than one component, or as individual components mixed in the chamber. Pre-mixing allows use of application means such as a showerhead.

In addition to the ranges set forth in the base process, in certain embodiments using the CF₄/N₂/Ar/H₂/C₄F₈ gas mixture, the pressures can be set at, or about, 300 mtorr for the arc open etch and at, or about, 30 mtorr for the main etch. Also, in some embodiments, the source power can be at, or about 0 Watts, during the arc open etch and at, or about, 1500 Watts during the main etch, the bias can be at, or about, 2000 Watts during the arc open etch and at, or about, 2800 Watts during the main etch.

The resulting etch rates obtained with this process, can vary depending on the embodiment. As shown herein, etch rates measured at greater than 5580 Å/min have been achieved by embodiments employing a CF₄/N₂/Ar/H₂/C₄F₈ gas mixture. In certain embodiments the etch duration is about 35 seconds for the arc open etch and about 20 seconds for the main etch. Also, in some embodiments, the photoresist selectivity can be about 2.7. Low etch rate and selectivity is caused by etch stop. Adding N₂ will reduce etch stop and increase the etch rate.

In separate embodiments of the present invention, fluorocarbons, such as C₄F₆ and C₅F₈, can be used in place of octafluorocyclobutane (C₄F₈).

### EXAMPLE 6:

An additional example of an embodiment of the present invention is an etching process that achieves an etch rate measured at greater than 5580 Å/min by using a high source and a low bias and a gas mixture which includes tetrafluoromethane (CF₄), nitrogen (N₂), argon (Ar), hydrogen (H₂) and Octafluorocyclobutane (C₄F₈). A 300 mm diameter wafer is used in this example. A structure formed by operation of this example is shown in cross-section in Figures 10A and B.

The first step of the method of this example is to provide a structure that will be etched in the following steps. The arrangement of layer of structure used in this example the same as that of Figure 4, as described in Example 1 above.

An Applied Centura Enabler Etch tool is used to etch the structure. In this example the etching performed is a two part etch, including the arc etch and then the main etch. The two part etch allows for the etching to be tailored to the particular material, or materials, being etched. During the arc etch, the BARC layer 440 and the DARC layer 430 are each etched through at the openings defined in the photoresist layer 450. Then, during the main etch, the ILD layer 420 is etched. With the barrier layer 410 positioned below the ILD layer 420, the main etch may terminate at the barrier layer 410.

At the beginning of both the arc etch and the main etch, the initial step is to apply the gas mixture at varying concentrations and types of gases. For the arc etch, the gas mixture includes 150 sccm of CF₄ and 30 sccm of CHF₃ at a pressure of 300 mtorr. For the main etch the mixture includes 65 sccm of CF₄, 170 sccm of N₂, 500 sccm of Ar, 20 sccm of H₂ and 10 sccm of C₄F₈, at a pressure of 30 mtorr.

With the gas applied the plasma is formed. The plasma formed for the arc etch is done with a bias of 2000 Watts and the source at 0 Watts. The Applied Centura Enabler Etch tool has the NSTU set at 1.35, the CSTU i/o set at 4/0, and the He in-out pressures at 10torr-10torr. For the main etch, the bias is 2800 Watts and the source is 1500 Watts, the reactor has the NSTU set at 4, the CSTU i/o set at 0/7, and the He in-out pressures at 15torr-15torr.

Once the plasma is formed for each of the etching stages, the structures are etched for different durations. In this example, for each set of the conditions as listed, the arc etch is performed for 35 seconds, and the main etch for 20 seconds.

Figures 10A and B set forth cross-sections of the etched structure after the arc and main etches in this example. As shown in Figure 10A, a structure 1000 has been etched to define vias 1060 and a trench 1070. The structure 1000 includes a barrier layer 1010, an ILD layer 1020, a DARC layer 1030, a BARC layer 1040, and a PR layer 1050.

The BD etch rate is measured at greater than 5580 Å/min, and the photoresist etch rate during the main etch is measured to be about 1950 Å/min. The resulting photoresist selectivity is about 2.7.

Figures 10A and B show that the profile of the formed vias and trench, tend to have tapered sidewalls, as their cross-sections and widths tend to decrease over their depth. Also, the etch stopped prior to reaching the etch stop layer. In Figure 10A, the vias 1060 have tapered sidewalls 1062 and the trench 1070 has tapered sidewalls 1072. The vias 1060 have some striations 1066 at, or about, the PR layer 1050. The vias 1060 are shown with a bottom or stop 1064, above the barrier layer 1010. Likewise, the trench 1070 is shown with a bottom or stop 1074, above the barrier layer 1010.

As such, it has been found with embodiments of the present invention that the addition of hydrogen (H₂) and Octafluorocyclobutane (C₄F₈) to the CF₄/N₂/Ar gas mixture, with the high source/relative low bias etch processes, results in a lower etch rate, lower photoresist selectivity, somewhat tapered profiles and slanted sidewalls. Also, it has been found that due to an high amount of polymer being produced the etch, in both the vias and the trench, is terminated prior to reaching the barrier layer.

However, the photoresist etch rate during main etch of about 1950 Å/min is lower than the main etch photoresist etch rate of about 2150 Å/min of the CF₄/N₂/Ar/CH₂F₂ gas mixture used in Example 5. This lower photoresist etch rate not only acts to aid preserving the photoresist, but also allows thinner photoresists to be employed. In addition, it has been found by the Applicants that by further increasing the flow rate of the C₄F₈ that the main etch photoresist etch rate can be further reduced and the photoresist selectivity can be increased, in certain situations to a measured value of about 10. Also, the addition of more H₂ has been found to further improve the process, as shown in Examples 8 and 9, herein.

### ETCH WITH CF₄/N₂/Ar/NH₃ GAS MIXTURE:

Some embodiments of the Applicants' invention achieve high etch rates by using high source and low bias settings with the addition of ammonia (NH₃) to the gas mixture of the base process set forth above. Specifically, in the method 200, a gas mixture containing tetrafluoromethane, nitrogen, argon and ammonia is used in the step of applying a gas mixture upon the etch material 220, as shown in Figure 2B.

The addition of ammonia to the base process allows control of the taper of the profile of etched opening. The ammonia provides for a reduction in the tapering of the profile with low selectivity to the barrier layer. That is, more vertical sidewalls in the etched opening can be obtained. The ammonia also helps to remove the etch residue. However, the addition of ammonia can also produce profiles with the walls shaped past the vertical in a bowing or bowed shape. The degree of bowing can be controlled by the amount of ammonia used. An example of etching with the addition of ammonia to the base process is set forth herein in Example 7.

As noted above in the description of the base process, a variety of different materials and layers can be etched with the CF₄/N₂/Ar/NH₃ gas mixture. One such usable structure is shown in Figure 3A.

Factors such as the types of gases, flow rates, source power and bias settings, chamber pressures, type of chamber, chamber settings, cooling, wafer size, etched material and layering, etch type, etch duration and the like, can include those set forth in detail in the base process. Of course, the resulting etch rate, depth and profile of the etched opening, selectivity and etch stop, and other items, can vary depending on such factors and the particular application of these embodiments. For example, the specific size (e.g. depth) and shape of the resulting formed opening can depend on various factors such as the size and position of the photoresist gap, the type of anti-reflective coating and dielectric, the source power levels, the bias power levels, the gas mixture, the duration of the etching, and the like.

The flow rates and ranges of flow rates of the CF₄, N₂ and Ar for both the arc open and the main etches are as set forth above in the base process. The flow rate of the ammonia can vary depending on the specific embodiment. For the arc open etch the range can be from 0 sccm to 100 sccm, and for the main etch from 0 sccm to 100 sccm. In certain embodiments, the ammonia is applied at, or about, 0 sccm for the arc open etch, and at, or about, 20 sccm for the main etch, as detailed herein.

The gases can be applied either as a preformed mix of the gas components), as a partial mixture of more than one component, or as individual components mixed in the chamber. By pre-mixing the gases can be applied by a means such as a showerhead.

In addition to the ranges set forth in the base process, in certain embodiments using the CF₄/N₂/Ar/NH₃ gas mixture, the pressures can be set at, or about, 300 mtorr for the arc open etch and at, or about, 30 mtorr for the main etch. Also, in some embodiments, the source power can be at, or about 0 Watts, during the arc open etch and at, or about, 1500 Watts during the main etch, the bias can be at, or about, 2000 Watts during the arc open etch and at, or about, 2800 Watts during the main etch.

The resulting etch rates obtained with this process, can vary depending on the embodiment. As shown herein, etch rates measured at about 9700 Å/min have been achieved by embodiments employing a CF₄/N₂/Ar/NH₃ gas mixture. In certain embodiments the etch duration is about 35 seconds for the arc open etch and about 20 seconds for the main etch. Also, in some embodiments, the photoresist selectivity can be about 6.

### EXAMPLE 7:

An example of an embodiment of the Applicants' invention is an etching process that achieves an etch rate measured at 9700 Å/min by using a high source and a low bias and a gas mixture which includes tetrafluoromethane (CF₄), nitrogen (N₂), argon (Ar) and ammonia (NH₃). A 300 mm diameter wafer is used in this example. Figures 11A and B show cross-sections of a structure formed by operation of this example.

The first step of the method of this example is to provide a structure that will be etched in the following steps. The arrangement of the layers of structure used in this example are the same as that of Figure 4, as described in Example 1 above.

An Applied Centura Enabler Etch tool is used to etch the structure. The etching is two part, including the arc etch and then the main etch. During the arc etch, the BARC layer 440 and the DARC layer 430 are each etched, and during the main etch the ILD layer 420 is etched, where the etch may terminate at the barrier layer 410.

At the beginning of both the arc etch and the main etch, the gas mixture is applied at various concentrations and types of gases. For the arc etch, the gas mixture includes 150 sccm of CF₄ and 30 sccm of CHF₃ at a pressure of 300 mtorr. For the main etch the mixture includes 65 sccm of CF₄, 170 sccm of N₂, 500 sccm of Ar, 20 sccm of NH₃, at a pressure of 30 mtorr.

For forming the plasma the arc etch the bias is 2000 Watts and the source is 0 Watts. The Applied Centura Enabler Etch tool has the NSTU set at 1.35, the CSTU i/o set at 4/0, and the He in-out pressures at 10torr-10torr. For the main etch, the bias is 2800 Watts and the source is 1500 Watts, the reactor has the NSTU set at 4, the CSTU i/o set at 0/7, and the He in-out pressures at 15torr-15torr.

Upon forming the plasma the structures are etched for different durations for each of the etching stages. In this example, for each set of the conditions as listed, the arc etch is performed for 35 seconds, and the main etch for 20 seconds.

Figures 11A and B set forth cross-sections of the etched structure after the arc and main etches in this example. As shown in Figure 11A, a structure 1100 has been etched to define vias 1160 and a trench 1170. The structure 1100 includes a barrier layer 1110, an ILD layer 1120, a DARC layer 1130, a BARC layer 1140, and a PR layer 1150.

The BD etch rate is measured at 9700 Å/min, and the photoresist etch rate during the main etch is measured to be about 1450 Å/min. The resulting photoresist selectivity is about 6.

Figures 11A and B show that the profile of the formed vias and trench, tend to have generally straight sidewalls, as their cross-sections and widths which tend to remain constant or slightly increase through their depth. In Figure 11A, the vias 1160 have generally straight sidewalls 1162 with some outward bowing, and the trench 1170 has generally straight sidewalls 1172 with some taper near the top. The vias 1160 have some striations 1166 at, or about, the PR layer 1150. The vias 1160 are shown with a bottom or stop 1164, somewhat above the barrier layer 1110. The trench 1170 is shown with a bottom or stop 1174, at the barrier layer 1110.

As a result, it has been found with embodiments of the present invention that the addition of ammonia (NH₃) to the CF₄/N₂/Ar gas mixture, with the high source/relative low bias etch processes, results in a high etch rate, high photoresist selectivity, sidewalls that are generally straight with some bowing outward.

### ETCH WITH CF₄/N₂/Ar/CH₂F₂/NH₃ GAS MIXTURE:

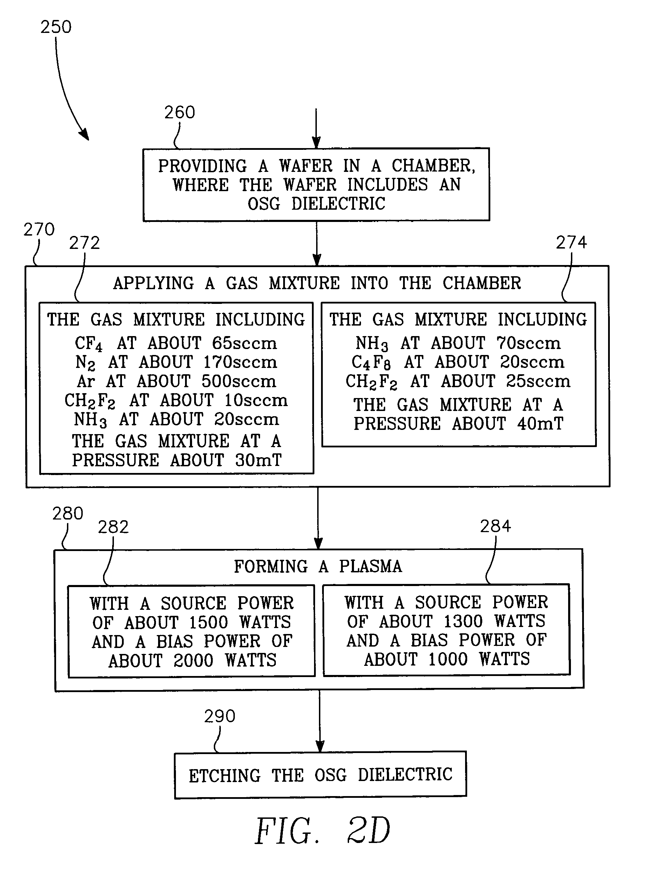

Other embodiments of the present invention achieve high etch rates by using the base process with the addition of a hydrofluorocarbon and ammonia (NH₃) to the gas mixture. In some embodiments, the added hydrofluorocarbon is difluoromethane (CH₂F₂). In particular, the step of applying a gas mixture upon the etch material 220 of the method 200, as shown in Figure 2A, uses a gas mixture containing tetrafluoromethane, nitrogen, argon, difluoromethane and ammonia, as shown in Figure 2B. Figure 2D shows a flow chart of an embodiment of such a method, as detailed herein.

Effects of the addition of difluoromethane include a higher etch rate and a change in the profile of the opening created during the etch. This is because the difluoromethane tends to cause the etch to occur at a faster rate. As a result, the profile of the opening etched with the addition of difluoromethane tends to be less tapered. That is, the sidewalls are more vertical with less of a inward taper. Also, difluoromethane can cause etch stop on trench-like features. Effects of adding ammonia include a reduction in the tapering of the profile and low selectivity to the barrier layer. The ammonia addition also helps remove the etch residue. However, ammonia can cause profile bowing, especially in via-like features. By using both difluoromethane and ammonia, features with straight profiles, i.e. vertical walls, can be created. An example of etching with the addition of difluoromethane and ammonia is set forth herein in Example 8.

As noted above in the description of the base process, a variety of different materials and layers can be etched with a CF₄/N₂/Ar/CH₂F₂/NH₃ gas mixture. One such usable structure is shown in Figure 3A.

Factors such as the types of gases, flow rates, source power and bias settings, chamber pressures, type of chamber, chamber settings, cooling, wafer size, etched material and layering, etch type, etch duration and the like, can include those set forth in detail in the base process. Of course, the resulting etch rate, depth and profile of the etched opening, selectivity and etch stop, and other items, can vary depending on such factors and the particular application of these embodiments. For example, the specific size (e.g. depth) and shape of the resulting formed opening can depend on various factors such as the size and position of the photoresist gap, the type of anti-reflective coating and dielectric, the source power levels, the bias power levels, the gas mixture, the duration of the etching, and the like.

The flow rates and ranges of flow rates of the CF₄, N₂ and Ar for both the arc open and the main etches are as set forth above in the base process. The difluoromethane flow rate can vary depending on the particular embodiment. During the arc open etch the difluoromethane can range from 0 sccm to 40 sccm, and from 0 sccm to 60 sccm for the main etch. In certain embodiments, the difluoromethane is applied at, or about, 0 sccm for the arc open etch, and at, or about, 10 sccm for the main etch, as detailed herein.

The flow rate of the ammonia can vary depending on the embodiment. For the arc open etch the range can be from 0 sccm to 100 sccm, and for the main etch from 0 sccm to 100 sccm. In certain embodiments, the ammonia is applied at, or about, 0 sccm for the arc open etch, and at, or about, 20 sccm for the main etch, as detailed herein.

The gases can be applied either as a preformed mix of the gas components), as a partial mixture of more than one component, or as individual components mixed in the chamber. In at least one embodiment, the difluoromethane and the ammonia can be applied into the chamber in separate or double flows. The gas mix can be supplied into the chamber by a showerhead or similar outlet.

In addition to the ranges set forth in the base process, in certain embodiments using the CF₄/N₂/Ar/CH₂F₂/NH₃ gas mixture, the pressures can be set at, or about, 300 mtorr for the arc open etch and at, or about, 30 mtorr for the main etch. Also, in some embodiments, the source power can be at, or about 0 Watts, during the arc open etch and at, or about, 1500 Watts during the main etch, the bias can be at, or about, 2000 Watts during the arc open etch and at, or about, 2800 Watts during the main etch.

The resulting etch rates obtained with this process, can vary depending on the embodiment. As shown herein, etch rates measured at about 11000 Å/min have been achieved by embodiments employing a CF₄/N₂/Ar/CH₂F₂/NH₃ gas mixture. In certain embodiments the etch duration is about 35 seconds for the arc open etch and about 20 seconds for the main etch. Also, with some embodiments, the photoresist selectivity can be about 5.1.

In separate embodiments of the present invention, hydrofluorocarbons, other than difluoromethane (CH₂F₂), can be used. These hydrofluorocarbons include CH₃F and CHF₃, can be used in place of difluoromethane (CH₂F₂).

Also, an alternate embodiment of the invention includes applying the methods of above embodiments of the invention to more polymerizing fluorocarbon gases like hexafluorobutadien (C₄F₆) or octafluorocyclobutane (C₄F₈). Examples of such embodiments are set forth below in Example 9.

Figure 2D shows a flow chart of at least one embodiment of the method of the present invention. The method 250 includes the steps of: Providing a wafer in a chamber, where the wafer includes an OSG dielectric 260; Applying a gas mixture into the chamber 270; Forming a plasma 280; and Etching the OSG dielectric 290. In addition, the step of applying a gas mixture into the chamber 270 can have the gas mixture including CF₄ at about 65 sccm, N₂ at about 170 sccm, Ar at about 500 sccm, CH₂F₂ at about 10 sccm, NH₃ at about 20 sccm, and the gas mixture at a pressure about 30mtorr 272. Also, the step of forming a plasma 280 can have with a source power of about 1500 Watts and a bias power of about 2000 Watts 282.

### EXAMPLE 8:

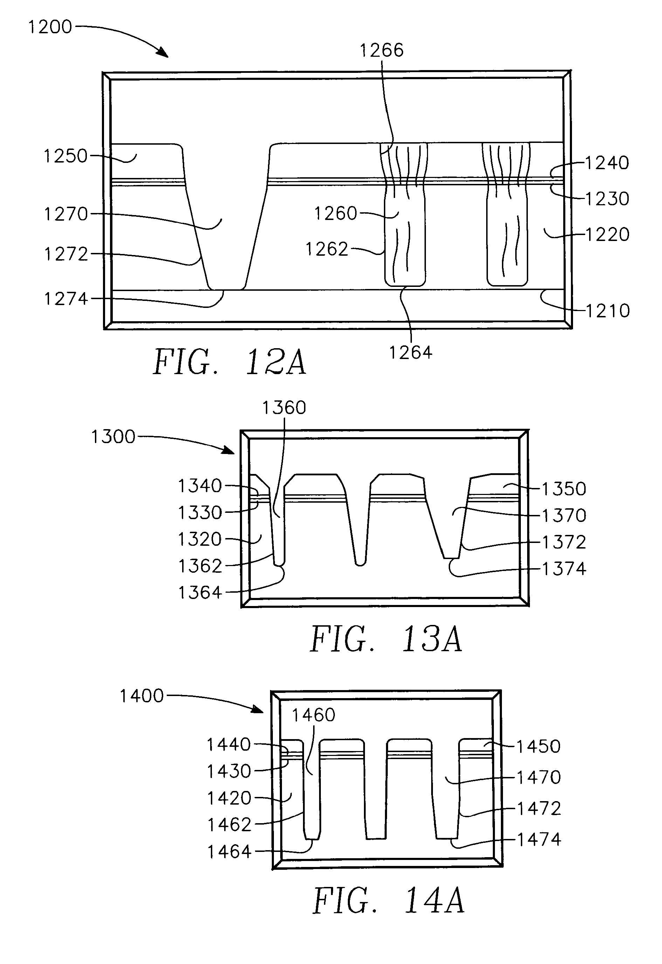

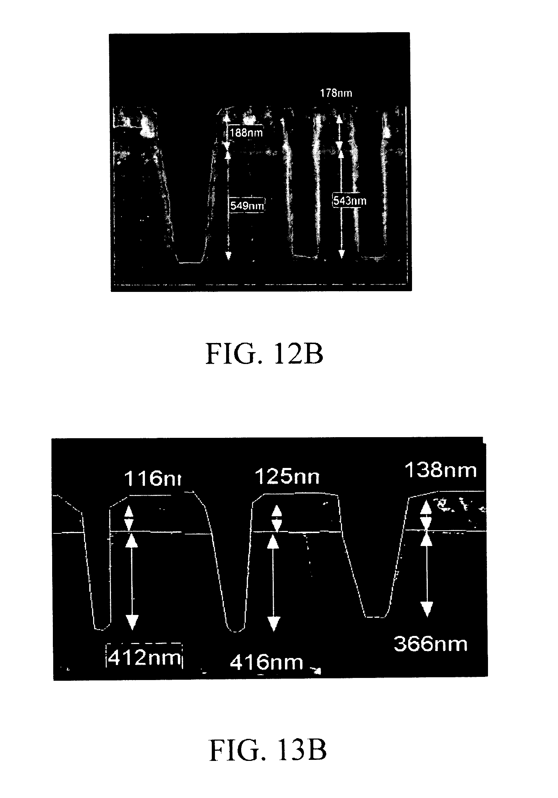

An example of an embodiment of the Applicants' invention is an etching process that achieves an etch rate measured at 11000 Å/min by using a high source and a low bias and a gas mixture which includes tetrafluoromethane (CF₄), nitrogen (N₂), argon (Ar), difluoromethane (CH₂F₂) and ammonia (NH₃). A 300 mm diameter wafer is used in this example. Figures 12A and B show cross-sections of a structure formed by operation of this example.

The first step of the method of this example is to provide a structure that will be etched in the following steps. The arrangement of layer of structure used in this example the same as that of Figure 4, as described in Example 1 above.

An Applied Centura Enabler Etch tool is used to etch the structure. The etching is two part, including the arc etch and then the main etch. During the arc etch, the BARC layer 440 and the DARC layer 430 are each etched and during the main etch the ILD layer 420 is etched, where the etch may terminate at the barrier layer 410.

At the beginning of both the arc etch and the main etch, the gas mixture is applied at various concentrations and types of gases. For the arc etch, the gas mixture includes 150 sccm of CF₄ and 30 sccm of CHF₃ at a pressure of 300 mtorr. For the main etch the mixture includes 65 sccm of CF₄, 170 sccm of N₂, 500 sccm of Ar, 10 sccm of CH₂F₂, and 20 sccm of NH₃, at a pressure of 30 mtorr.

The next step for each etch is forming the plasma. For the arc etch the bias is 2000 Watts and the source is 0 Watts. The Applied Centura Enabler Etch tool has the NSTU set at 1.35, the CSTU i/o set at 4/0, and the He in-out pressures are 10torr-10torr. For the main etch, the bias is 2800 Watts and the source is 1500 Watts, the reactor has the NSTU set at 4, the CSTU i/o set at 0/7, and the He in-out pressures at 15torr-15torr.

Upon forming the plasma the structures are etched for different durations for each of the etching stages. In this example, for each set of the conditions as listed, the arc etch is performed for 35 seconds, and the main etch for 20 seconds.

Figures 12A and B set forth cross-sections of the etched structure after the arc and main etches in this example. As shown in Figure 12A, a structure 1200 has been etched to define vias 1260 and a trench 1270. The structure 1200 includes a barrier layer 1210, an ILD layer 1220, a DARC layer 1230, a BARC layer 1240, and a PR layer 1250.

The BD etch rate is measured at about 11000 Å/min, and the photoresist etch rate during the main etch is measured to be about 2150 Å/min. The resulting photoresist selectivity is about 5.1.

Figures 12A and B show that the profile of the formed vias tend to have substantially straight and vertical sidewalls and the trench tends to have tapered sidewalls. In Figure 12A, the vias 1260 have substantially straight and vertical sidewalls 1262, and the trench 1270 has somewhat tapered sidewalls 1272. The vias 1260 have some striations 1266 at, or about, the PR layer 1250. The vias 1260 are shown with a bottom or stop 1264, just above the barrier layer 1210. The trench 1270 is shown with a bottom or stop 1274, at the barrier layer 1210.

As a result, it has been found with embodiments of the present invention that the addition of difluoromethane (CH₂F₂) and ammonia (NH₃) to the CF₄/N₂/Ar gas mixture, with the high source/relative low bias etch processes, results in a high etch rate, high photoresist selectivity, and sidewalls that are substantially straight and vertical.

The same approach as in Example 8 can be applied to more polymerizing fluorocarbon gases like C₄F₆ or C₄F₈ as detailed in Example 9 below.

### ETCH WITH CF₄/N₂/Ar/NH₃/C₄F₈/CH₂F₂ GAS MIXTURE:

Additional embodiments of the present invention achieve high etch rates by using the base process with the addition of ammonia (NH₃), a fluorocarbon, and a hydrofluorocarbon to the gas mixture. In some embodiments, the added fluorocarbon is octafluorocyclobutane (C₄F₈) and the added hydrofluorocarbon is difluoromethane (CH₂F₂). In particular, the step of applying a gas mixture upon the etch material 220 of the method 200, as shown in Figure 2A. The gas mixture contains tetrafluoromethane, nitrogen, argon, ammonia octafluorocyclobutane and difluoromethane, as shown in Figure 2B. Figure 2D shows a flow chart of an embodiment of such a method, as detailed herein.

Effects of adding ammonia include a reduction in the tapering of the profile and low selectivity to the barrier layer. The ammonia addition also helps remove the etch residue. However, ammonia can cause profile bowing, especially in via-like features. By using both difluoromethane and ammonia, features with straight profiles, i.e. vertical walls, can be created. Octafluorocyclobutane is a more polymerizing gas and because of the high levels of polymer tends to early etch stop. Effects of the addition of difluoromethane include a higher etch rate and a change in the profile of the opening created during the etch. This is because the difluoromethane tends to cause the etch to occur at a faster rate. As a result, the profile of the opening etched with the addition of difluoromethane tends to be less tapered. That is, the sidewalls are more vertical with less of a inward taper. Also, difluoromethane can cause etch stop on trench-like features. An example of etching with the addition of ammonia octafluorocyclobutane and difluoromethane is set forth herein in Example 9.

As noted above in the description of the base process, a variety of different materials and layers can be etched with a CF₄/N₂/Ar/NH₃/C₄F₈/CH₂F₂ gas mixture. One such usable structure is shown in Figure 3A.

Factors such as the types of gases, flow rates, source power and bias settings, chamber pressures, type of chamber, chamber settings, cooling, wafer size, etched material and layering, etch type, etch duration and the like, can include those set forth in detail in the base process. Of course, the resulting etch rate, depth and profile of the etched opening, selectivity and etch stop, and other items, can vary depending on such factors and the particular application of these embodiments. For example, the specific size (e.g. depth) and shape of the resulting formed opening can depend on various factors such as the size and position of the photoresist gap, the type of anti-reflective coating and dielectric, the source power levels, the bias power levels, the gas mixture, the duration of the etching, and the like.

The flow rates and ranges of flow rates of the CF₄, N₂ and Ar for both the arc open and the main etches are as set forth above in the base process. The flow rate of the ammonia can vary depending on the embodiment. For the arc open etch the range can be from 0 sccm to 100 sccm, and for the main etch from 0 sccm to 100 sccm. In certain embodiments, the ammonia is applied at, or about, 0 sccm for the arc open etch, and at, or about, 70 sccm for the main etch, as detailed herein.

The amount of octafluorocyclobutane gas used during the etch of the etch material can vary depending on the embodiment of the method. During the arc open etch the octafluorocyclobutane can range from 0 sccm to 10 sccm, and from 0 sccm to 35 sccm for the main etch. In certain embodiments, the octafluorocyclobutane is applied at, or about, 0 sccm for the arc open etch, and at, or about, 25 sccm for the main etch.

The difluoromethane flow rate can vary depending on the particular embodiment. During the arc open etch the difluoromethane can range from 0 sccm to 40 sccm, and from 0 sccm to 40 sccm for the main etch. In certain embodiments, the difluoromethane is applied at, or about, 0 sccm for the arc open etch, and at, or about, 20 sccm for the main etch, as detailed herein.

The gases can be applied either as a preformed mix of the gas components), as a partial mixture of more than one component, or as individual components mixed in the chamber. In at least one embodiment, the difluoromethane and the ammonia can be applied into the chamber in separate or double flows. The gas mix can be supplied into the chamber by a showerhead or similar outlet.

In addition to the ranges set forth in the base process, in certain embodiments using the CF₄/N₂/Ar/NH₃/C₄F₈/CH₂F₂ gas mixture, the pressures for 200mm wafers can be set at, or about, 300 mtorr for the arc open etch and at, or about, 40 mtorr for the main etch. Also, in some embodiments, the source power during the arc open etch for 200mm wafers can be at, or about 0 Watts, and for 300mm wafers can be at, or about 0 Watts. The source power during the main etch for 200mm wafers can be at, or about 1300 Watts, and for 300mm wafers can be at, or about 1300 Watts. the bias during the arc open etch for 200mm wafers can be at, or about 1000 Watts, and for 300mm wafers can be at, or about 2000 Watts. The bias during the main etch for 200mm wafers can be at, or about 1000 Watts, and for 300mm wafers can be at, or about 2000 Watts.

The resulting etch rates obtained with this process, can vary depending on the embodiment. As shown herein, etch rates measured at about 18900 Å/min have been achieved by embodiments employing a CF₄/N₂/Ar/NH₃/C₄F₈/CH₂F₂ gas mixture. In certain embodiments the etch duration is about 30 seconds for the arc open etch and about 13 seconds for the main etch. Also, with some embodiments, the photoresist selectivity can be about 9:1.

In separate embodiments of the present invention, hydrofluorocarbons, other than difluoromethane (CH₂F₂), can be used. These hydrofluorocarbons include CH₃F and CHF₃, can be used in place of difluoromethane (CH₂F₂). Fluorocarbons, other than octafluorocyclobutane (C₄F₈), can be used, such as C₄F₆ and C₅F₈.

Also, if after the etch with the CF₄/N₂/Ar/NH₃/C₄F₈/CH₂F₂ gas mixture the profile of the feature still has some taper an over-etch step can be added. This over-etch step can be selective to the bottom barrier and include a C₄F₆/N₂/Ar gas mixture to straighten the feature profile.

Figure 2D shows a flow chart of an embodiment of the methods of the present invention. The method 250 includes the steps of: Providing a wafer in a chamber, where the wafer includes an OSG dielectric 260; Applying a gas mixture into the chamber 270; Forming a plasma 280; and Etching the OSG dielectric 290. In addition, the step of applying a gas mixture into the chamber 270 can have the NH₃ at about 70 sccm, C₄F₈ at about 20 sccm, and CH₂F₂ at about 25 sccm, and the gas mixture at a pressure about 40mtorr 274. Also, the step of forming a plasma 280 can have with a source power of about 1300 Watts and a bias power of about 1000 Watts 284.

### EXAMPLE 9:

Another example of an embodiment of the Applicants' invention is an etching process that adds ammonia (NH₃) to a octafluorocyclobutane (C₄F₈) and difluoromethane (CH₂F₂) mixture. With employing a high source power plasma, this first gas mixture results in a OSG etching rate close to 20000 Å/min. Figures 13A and B show results of such a process.

In this example, a 200mm wafer Enabler system is used. During the main etch the source power is set at 1300 Watts and the bias power at 1000 Watts. The gas mixture has flows of 70 sccm of NH₃, 20 sccm of CH₂F₂ and 25 sccm of C₄F₈ at 40mtorr of pressure. The Applied Centura Enabler Etch tool has the NSTU set at 4, the CSTU i/o set at 0/7, and the He in-out pressures are 15torr-15torr. The duration of the main etch is 13 seconds.

This results in a measured etching rate of OSG of 18,900A/min with a photoresist selectivity of about 9:1. As can be seen in Figures 13A and B, the profile resulting from the etch of this example has a small amount of taper.

As shown in Figure 13A, a structure 1300 has been etched to define vias 1360 and a trench 1370. The structure 1300 includes an ILD layer 1320, a DARC layer 1330, a BARC layer 1340, and a PR layer 1350. The vias 1360 have a small amount of taper in their sidewalls 1362, and the trench 1370 has somewhat tapered sidewalls 1372. The vias 1360 are shown with a bottom or stop 1364 that is somewhat rounded. The trench 1370 is shown with a bottom or stop 1374.

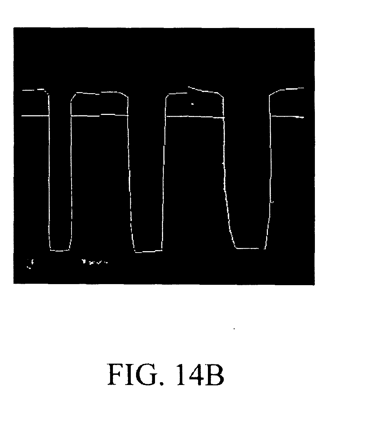

However, as shown in Figure 14A and B, with the addition of an over-etch step employing a second gas mixture of C₄F₆/N₂/Ar, which is selective to the bottom barrier, a straight final profile is achievable.

As shown in Figure 14A, a structure 1400 has been etched to define vias 1460 and a trench 1470. The structure 1400 includes an ILD layer 1420, a DARC layer 1430, a BARC layer 1440, and a PR layer 1450. The vias 1460 have straight sidewalls 1462, and the trench 1470 has straight sidewalls 1472. The vias 1460 are shown with a bottom or stop 1464 that is generally flat. The trench 1470 is shown with a bottom or stop 1474 that is generally flat.

Another example is similar to that set forth in Example 9, except with hexafluorobutadien (C₄F₆) used in place of C₄F₈.

While some embodiments of the present invention have been described in detail above, many changes to these embodiments may be made without departing from the true scope and teachings of the present invention. The present invention, therefore, is limited only as claimed below and the equivalents thereof.

## Claims

1. A plasma etching method comprising:
a) applying a gas mixture comprising CF₄, N₂ and Ar; and
b) forming a high density and low bombardment energy plasma.

2. The plasma etching method of Claim 1, wherein the high density and low bombardment energy plasma is formed by a high source power and a low bias power.

3. The plasma etching method of Claim 2, wherein the high source power is between about 0 Watts and about 2000 Watts, and wherein the low bias power is between about 1000 Watts and about 3000 Watts.

4. The plasma etching method of any of Claims 1 to 3, wherein the high density and low bombardment energy plasma has an electron density of about 5x10¹⁰ electrons/cm³.

5. The plasma etching method of any of Claims 1 to 3, wherein the high density and low bombardment energy plasma has an electron density greater than 5x10¹⁰ electrons/cm³.

6. The plasma etching method of Claim 5, wherein the high density and low bombardment energy plasma has an electron density greater than 1x10¹¹ electrons/cm³.

7. The plasma etching method of Claim 1, wherein the gas mixture further comprises H₂.

8. The plasma etching method of Claim 7, wherein the gas mixture further comprises a fluorocarbon gas.

9. The plasma etching method of Claim 8, wherein the fluorocarbon gas comprises at least one of: (1) C₄F₈; (2) C₄F₆; or (3) C₅F₈.

10. The plasma etching method of Claim 1, wherein the gas mixture further comprises a hydrofluorocarbon gas.

11. The plasma etching method of Claim 10, wherein the hydrofluorocarbon gas comprises at least one of: (1) CH₂F₂; (2) CH₃F; or (3) CHF₃.

12. The plasma etching method of Claim 1, wherein the gas mixture further comprises NH₃.

13. The plasma etching method of Claim 12, wherein the gas mixture further comprises a hydrofluorocarbon gas.

14. The plasma etching method of Claim 13, wherein the hydrofluorocarbon gas comprises at least one of: (1) CH₂F₂; (2) CH₃F; or (3) CHF₃.

15. The plasma etching method of Claim 13, wherein the gas mixture further comprises a fluorocarbon gas.

16. The plasma etching method of Claim 15, wherein the fluorocarbon gas comprises at least one of: (1) C₄F₈; (2) C₄F₆; or C₅F₈.

17. The plasma etching method of Claim 1, further comprising etching a semiconductor wafer.

18. The plasma etching method of Claim 17, wherein the semiconductor wafer comprises a dielectric material (130; 330; 420), and wherein etching the semiconductor wafer comprises etching the dielectric material.

19. The plasma etching method of Claim 18, wherein etching the dielectric material is at an etch rate of greater than 7000 Å/min.

20. A method for etching a feature in a plasma reactor, the method comprising:
a) providing a semiconductor wafer;
b) applying upon the semiconductor wafer a gas mixture comprising CF₄, N₂ and Ar;
c) forming a high density and low bombardment energy plasma; and
d) etching the semiconductor wafer to form a feature in the semiconductor wafer.

21. The method of Claim 20, wherein the high density and low bombardment energy plasma has an electron density of about 5x10¹⁰ electrons/cm³.

22. The method of Claim 20, wherein the high density and low bombardment energy plasma has an electron density greater than 5x10¹⁰ electrons/cm³.

23. The method of Claim 22, wherein the high density and low bombardment energy plasma has an electron density greater than 1x10¹¹ electrons/cm³.

24. The method of any of Claims 20 to 24, wherein the high density and low bombardment energy plasma is formed by a high source power and a low bias power.

25. The method of any of Claims 20 to 24, wherein the semiconductor wafer has a diameter of about 300 mm.

26. The method of Claim 25, wherein the high source power is between about 0 Watts and about 2000 Watts, and wherein the low bias power is between about 1000 Watts and about 3000 Watts.

27. The method of Claim 26, wherein the high source power is between about 500 Watts and about 2000 Watts.

28. The method of Claim 26, wherein the high source power is about 1000 Watts, and wherein the low bias power is about 2800 Watts.

29. The method of Claim 26, wherein the high source power is about 1500 Watts, and wherein the low bias power is about 2800 Watts.

30. The method of any of Claims 20 to 24, wherein the semiconductor wafer has a diameter of about 200 mm.

31. The method of Claim 30, wherein the high source power is between about 0 Watts and about 2000 Watts, and wherein the low bias power is between about 500 Watts and about 1500 Watts.

32. The method of Claim 31, wherein the high source power is between about 500 Watts and about 2000 Watts.

33. The method of Claim 31, wherein the high source power is about 1500 Watts, and wherein the low bias power is about 1400 Watts.

34. The method of any of Claims 20 to 33, wherein the semiconductor wafer comprises a dielectric material (130; 330; 420) and wherein etching the semiconductor wafer comprises etching the dielectric to form a feature in the dielectric material.

35. The method of Claim 34, wherein the dielectric material is a low-k dielectric material.

36. The method of Claim 34, wherein the dielectric material has a dielectric constant, and wherein the dielectric constant is between about 2 and about 3.7.

37. The method of Claim 36, wherein applying upon the semiconductor wafer a gas mixture comprises applying the CF₄ at a flow rate of about 65 sccm, applying the N₂ at a flow rate of about 170 sccm and applying the Ar at a flow rate of about 500 sccm.

38. The method of Claim 34, wherein etching the dielectric material is at an etch rate of greater than 7000 Å/min.

39. The method of Claim 34, wherein etching the dielectric material is at an etch rate of greater than about 9000 Å/min.

40. The method of Claim 34, wherein etching the dielectric material is at an etch rate of between about 9000 Å/min and about 20000 Å/min.

41. The method of any of Claims 34 to 38, wherein the feature comprises a sidewall, and wherein the sidewall (562, 572; 662, 672; 762, 772)is substantially vertical.

42. The method of any of Claims 34 to 38, wherein etching the dielectric (130; 330; 420) is substantially along a first direction, wherein the feature comprises a sidewall, and wherein the sidewall is substantially aligned with the first direction of the etching of the dielectric.

43. The method of any of Claims 20 to 42, wherein the gas mixture further comprises H₂.

44. The method of Claim 43, wherein the H₂ is applied at a flow rate of about 20 sccm.

45. The method of Claim 43, wherein the gas mixture further comprises at least one of: (1) C₄F₈; (2) C₄F₆; or (3) C₅F₈.

46. The method of Claim 43, wherein the gas mixture further comprises C₄F₈ applied at a flow rate of about 10 sccm.

47. The method of any of Claims 20 to 42, wherein the gas mixture further comprises at least one of: (1) CH₂F₂; (2) CH₃F; or (3) CHF₃.

48. The method of any of Claims 20 to 42, wherein the gas mixture further comprises CH₂F₂ applied at a flow rate of about 10 sccm.

49. The method of any of Claims 20 to 42, wherein the gas mixture further comprises NH₃.

50. The method of any of Claims 20 to 42, wherein the gas mixture further comprises NH₃ applied at a flow rate of about 20 sccm.

51. The method of Claim 49, wherein the gas mixture further comprises at least one of: (1) CH₂F₂; (2) CH₃F; or (3) CHF₃.

52. The method of any of Claims 49 to 50, wherein the gas mixture further comprises CH₂F₂ applied at a flow rate of about 10 sccm.

53. The method of Claim 51, wherein the gas mixture further comprises at least one of: (1) C₄F₈; (2) C₄F₆; or C₅F₈.

54. The method of Claim 30, wherein the gas mixture further comprises NH₃, C₄F₈ and CH₂F₂.

55. The method of Claim 30, wherein the gas mixture further comprises NH₃, C₄F₆ and CH₂F₂.

56. The method of Claim 54, wherein applying upon the semiconductor wafer a gas mixture comprises applying the CF₄ at a flow rate of about 0 sccm, applying the N₂ at a flow rate of about 0 sccm and applying the Ar at a flow rate of about 0 sccm, applying the NH₃ at a flow rate of about 70 sccm, applying the C₄F₈ at a flow rate of about 25 sccm, and applying the CH₂F₂ at a flow rate of about 20 sccm.

57. The method of Claim 56, wherein applying upon the semiconductor wafer a gas mixture comprises applying the gas mixture at a pressure of about 40 mtorr.

58. The method of Claim 57, wherein the method further comprises applying an over-etch gas mixture.

59. The method of Claim 58, wherein applying an over-etch gas mixture comprises applying a gas mixture comprising C₄F₆, N₂ and Ar.

60. The method of Claim 20, wherein the feature comprises at least one of: (1) a via (560; 660; 760); or (2) a trench (570; 670; 770).

61. An etching method comprising:
a) providing a wafer in a chamber, wherein the wafer comprises an OSG dielectric;
b) applying a first gas mixture into the chamber, wherein the first gas mixture comprises CF₄ at a flow rate of about 65 sccm, N₂ at a flow rate of about 170 sccm, Ar at a flow rate of about 500 sccm, CH₂F₂ at a flow rate of about 10 sccm, NH₃ at a flow rate of about 20 sccm, and wherein the pressure of the first gas mixture is about 30mtorr;
c) forming a plasma with a source power of about 1500 Watts and a bias power of about 2800 Watts; and
d) etching the OSG dielectric.

62. The etching method of Claim 61, wherein etching the OSG dielectric further comprises etching the OSG dielectric to form at least one of: (1) a via (570; 670; 770); or (2) a trench (572; 672; 772).

63. The etching method of any of Claims 61 to 62, Wherein the OSG dielectric has a dielectric constant, and wherein the dielectric constant is between about 2 and about 3.7.

64. The etching method of any of Claims 61 to 63, wherein etching the OSG dielectric comprises etching for about 20 seconds.

65. The etching method of any of Claims 61 to 64, wherein etching the OSG dielectric comprises etching at an etch rate of about 11000 Å/min.

66. An etching method comprising:
a) providing a wafer in a chamber, wherein the wafer comprises an OSG dielectric;
b) applying a first gas mixture into the chamber, wherein the first gas mixture comprises NH₃ at a flow rate of about 70 sccm, C₄F₈ at a flow rate of about 20 sccm, and CH₂F₂ at a flow rate of about 25 sccm, and wherein the pressure of the first gas mixture is about 40mT;
c) forming a plasma with a source power of about 1300 Watts and a bias power of about 1000 Watts; and
d) etching the OSG dielectric.

67. The etching method of Claim 66, further comprising applying into the chamber a second gas mixture comprising C₄F₆, N₂ and Ar to etch the OSG dielectric.

68. The etching method of any of Claims 66 to 67, Wherein the OSG dielectric has a dielectric constant, and wherein the dielectric constant is between about 2 and about 3.7.

69. The etching method of any of Claims 66 to 68, wherein etching the OSG dielectric comprises etching for about 13 seconds.

70. The etching method of any of Claims 66 to 69, wherein etching the OSG dielectric comprises etching at an etch rate of about 18,900 Å/min.

71. A plasma etching tool comprising a chamber capable of receiving a wafer, wherein the chamber has a gas mixture comprising CF₄, N₂ and Ar, and wherein the chamber has a high density and low bombardment energy plasma formed therein.

72. The plasma etching tool of Claim 71, wherein the high density and low bombardment energy plasma is formed by a high source power and a low bias power, wherein the high source power is between about 0 Watts and about 2000 Watts, and wherein the low bias power is between about 1000 Watts and about 3000 Watts.

73. The plasma etching tool of any of Claims 71 to 72, wherein the high density and low bombardment energy plasma has an electron density of at least 5x10¹⁰ electrons/cm³.

74. The plasma etching tool any of Claims 71 to 73, wherein the gas mixture further comprises H₂.

75. The plasma etching tool any of Claims 71 to 74, wherein the gas mixture further comprises a fluorocarbon gas.

76. The plasma etching tool any of Claims 71 to 75, wherein the gas mixture further comprises a hydrofluorocarbon gas.

77. The plasma etching tool any of Claims 71 to 76, wherein the gas mixture further comprises NH₃.
